(19) Europäisches Patentamt
European Patent Office
Office européen des brevets

(11) **EP 1 937 471 B1**

(12) **EUROPÄISCHE PATENTSCHRIFT**

(45) Veröffentlichungstag und Bekanntmachung des Hinweises auf die Patenterteilung:
**12.02.2014   Patentblatt 2014/07**

(21) Anmeldenummer: **06776694.9**

(22) Anmeldetag: **09.08.2006**

(51) Int Cl.:
**B32B 15/08** *(2006.01)*      **B44C 1/17** *(2006.01)*

(86) Internationale Anmeldenummer:
**PCT/EP2006/007860**

(87) Internationale Veröffentlichungsnummer:
**WO 2007/045294 (26.04.2007 Gazette 2007/17)**

(54) **MEHRSCHICHTKÖRPER SOWIE VERFAHREN ZU DESSEN HERSTELLUNG**

MULTI-LAYER BODY AND METHOD FOR PRODUCING THE SAME

CORPS MULTICOUCHE ET PROCEDE DE REALISATION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **17.10.2005   DE 102005049891**

(43) Veröffentlichungstag der Anmeldung:
**02.07.2008   Patentblatt 2008/27**

(73) Patentinhaber: **Leonhard Kurz Stiftung & Co. KG**
**90763 Fürth (DE)**

(72) Erfinder:
• **STAUB, René**
  **CH-6332 Hagendorn (CH)**
• **KURZ, Walter**
  **90768 Fürth (DE)**

(74) Vertreter: **Zinsinger, Norbert**
**Louis Pöhlau Lohrentz**
**P.O. Box 30 55**
**90014 Nürnberg (DE)**

(56) Entgegenhaltungen:
**EP-A- 0 790 123      WO-A-99/48703**
**DE-A1- 4 307 487     US-A- 4 643 912**
**US-A- 4 759 969**

**Beschreibung**

Die Erfindung betrifft einen Mehrschichtkörper mit einer Replizierschicht, die mikroskopisch feine Musterbereiche aufweist, sowie ein Verfahren zur Herstellung eines Mehrschichtkörpers mit einstellbarer bzw. definierter elektrischer Leitfähigkeit.

Es sind metallisierte Mehrschichtkörper, insbesondere metallisierte Folien bekannt, die eine spiegelnde oder matte oder sonstwie strukturierte Oberfläche aufweisen, die elektrisch leitend ist. Die elektrisch leitende Oberfläche kann störend sein, beispielsweise wenn die Folien zur Dekoration von Gehäusen elektronischer Geräte vorgesehen sind oder wenn die Folien als Verpackung für Lebensmittel dienen sollen, die der elektromagnetischen Strahlung eines Mikrowellenherdes ausgesetzt wird. Solche Verpackungen können zugleich Sicherheitsmerkmale mit metallischer Oberfläche enthalten, die ebenfalls durch Mikrowellenstrahlung thermisch zerstört werden können.

Der Erfindung liegt nun die Aufgabe zugrunde, einen Mehrschichtkörper mit einstellbarer bzw. definierter elektrischer Leitfähigkeit anzugeben sowie ein Herstellungsverfahren dazu, das kostengünstig und für Massenproduktion geeignet ist.

Die Aufgabe der Erfindung wird mit einem Verfahren zur Herstellung eines Mehrschichtkörpers mit einstellbarer bzw. definierter elektrischer Leitfähigkeit gelöst, wobei vorgesehen ist, daß in einem ersten Bereich einer Replizierschicht des Mehrschichtkörpers eine diffraktive erste Oberflächenstruktur abgeformt wird, daß eine metallische Schicht auf die Replizierschicht in dem ersten Bereich und in einem zweiten Bereich, in dem die erste Oberflächenstruktur nicht in die Replizierschicht abgeformt ist, aufgebracht wird, wobei entweder der erste Bereich oder der zweite Bereich von einer Vielzahl mikroskopisch feiner Musterbereiche gebildet wird, die in einem Linienraster oder in einem Flächenraster mit der Rastenrveite D angeordnet sind und die jeweils durch den, jeden der Teilbereiche vollständig begrenzenden oder umschließenden zweiten Bereich bzw. ersten Bereich voneinander getrennt in einem Abstand B voneinander angeordnet sind, daß auf die metallische Schicht eine photoempfindliche Schicht aufgebracht wird oder als Replizierschicht eine photoempfindliche Waschmaske aufgebracht wird, daß die photoempfindliche Schicht bzw. Waschmaske durch die metallische Schicht hindurch belichtet wird, so daß die photoempfindliche Schicht bzw. Waschmaske durch die erste Oberflächenstruktur bedingt im ersten und im zweiten Bereich unterschiedlich belichtet wird, und daß die metallische Schicht unter Verwendung der belichteten photoempfindlichen Schicht bzw. Waschmaske als Maskenschicht im ersten Bereich, nicht jedoch im zweiten Bereich, oder im zweiten Bereich, nicht jedoch im ersten Bereich entfernt wird.

Die Aufgabe wird weiter mit einem Mehrschichtkörper, insbesondere einer Transferfolie, mit einer Replizierschicht und einer auf der Replizierschicht angeordneten metallischen Schicht gelöst, wobei vorgesehen ist, daß der Mehrschichtkörper eine Vielzahl mikroskopisch feiner Musterbereiche und einen jeden der Musterbereiche vollständig begrenzenden oder umschließenden Hintergrundbereich aufweist, wobei die Musterbereiche in einem Linienraster oder in einem Flächenraster mit der Rasterweite D angeordnet sind, die Musterbereiche jeweils durch den Hintergrundbereich voneinander getrennt in einem Abstand B voneinander angeordnet sind, die Rasterweite D kleiner als 500 $\mu$m ist und das Verhältnis der Rasterweite D zum Abstand B im Bereich von 5 bis 200 liegt, und daß die metallische Schicht entweder im Hintergrundbereich oder in den Musterbereichen entfernt ist.

Es ist also vorgesehen, daß zur Herstellung von an einem Raster ausgerichteten, mikroskopisch feinen Inselstrukturen die auf die Oberflächenstruktur aufgebrachte metallische Schicht selbst eine optische Belichtungsmaske bildet, wobei die optische Wirkung der metallischen Schicht jeweils durch die Oberflächenstruktur bestimmt ist, auf der sie angeordnet ist. Auf diese Weise kann eine registerhaltige teilweise Entfernung der als Belichtungsmaske fungierenden metallischen Schicht selbst erzielt werden, und zwar in der hohen Auflösung und Qualität, die für die Herstellung der mikroskopisch feinen Inselstrukturen erforderliche ist.

Der Begriff "Raster" wird hier nicht nur als gleichmäßige Unterteilung einer Fläche gebraucht. Vielmehr sind auch ungleichmäßige oder zufällige Raster, wie beispielsweise frequenzmodulierte Raster, wie sie in der Druckindustrie verwendet werden, unter "Raster" verstanden. Es sind also ausdrücklich Unterteilungen der Fläche in Inselbereiche eingeschlossen, die völlig stochastisch gebildet sind. Die Linien zwischen den Inselbereichen können  auch gekrümmt sein und/oder von variierender Dicke sein. Bei der Rasterweite D und/oder dem Abstand B kann es sich auch um Mittelwerte der Gesamtheit handeln. Weiter kann es sich um Linienraster, d.h. um eindimensionale Raster oder um mehrdimensionale Raster handeln, beispielsweise um Flächenraster.

Durch die Erfindung wird somit ein Herstellungsverfahren für partiell metallisierte Mehrschichtkörper, insbesondere partiell metallisierte Folien mit mikroskopisch feinen Inselstrukturen angegeben, welches besonders effektiv und kostengünstig ist.

Durch die besondere Strukturierung eines erfindungsgemäßen Mehrschichtkörpers werden weiter folgende Vorteile erzielt:

Diese Strukturierung ist durch das unbewaffnete menschliche Auge nicht wahrnehmbar. So erscheint die metallische Schicht eines erfindungsgemäßen Mehrschichtkörpers, der mit der oben spezifizierten Anordnung von metallisierten inselförmigen Musterbereiche versehen ist, dem unbewaffneten menschlichen Auge einerseits als homogene metallische Oberfläche. Andererseits ist die metallische Schicht elektrisch nicht leitfähig, jedoch durchgängig für elektromagnetische Strahlung bis hin zum Mikrowellenbereich. Der Mehrschichtkörper kann deshalb beispielsweise der Strahlung einer Mikrowelle ausgesetzt werden, ohne sich merklich zu erhitzen. Damit ist mittels des erfindungsgemäßen Mehrschichtkörpers eine metallisch erscheinende, aber elektrisch nicht leitfähige Oberfläche realisierbar. Durch geeignete Ausgestaltung der Parameter, wie beispielsweise Rasterweite D und/oder Abstand B der Musterbereiche und/oder der Art des Rasters kann zudem der Effekt der elektrischen Leitfähigkeit frequenzabhängig gestaltet werden. Dies bedeutet, dass je nach Anregungsfrequenz eine elektrische Leitfähigkeit vorliegen kann oder nicht.

Wenn es sich beispielsweise bei den Musterbereichen um spiegelnde Bereiche handelt, wird ein als Folie ausgebildeter Mehrschichtkörper als eine metallische Spiegelfolie wahrgenommen. Eine solche Folie kann beispielsweise zur Dekoration von elektrischen Geräten, wie etwa Fernsehempfängern, verwendet werden, die eine elektrisch nichtleitende Oberfläche aufweisen sollen.

Andererseits kann durch Variation der Oberflächenstruktur eine transparente Folie hergestellt werden, die eine elektrisch leitende Oberfläche aufweist. Eine solche elektrisch leitfähige Folie kann beispielsweise demetallisierte Musterbereiche aufweisen, die von einem metallisierten Hintergrundbereich umgeben sind. Diese Folie kann beispielsweise als transparente Abschirmfolie verwendet werden, die trotz ihrer Transparenz wegen des netzartig ausgebildeten metallisierten Hintergrundbereichs elektromagnetische Strahlung abzuschirmen oder statische elektrische Ladungen abzuleiten vermag.

Beliebige elektrische Leitfähigkeiten lassen sich beispielsweise durch Variation der Schichtdicke der metallischen Schicht oder durch Variation des Verhältnisses D/B einstellen.

Wenn ein Linienraster vorgesehen ist, kann beispielsweise ein Mehrschichtkörper als eine Folie ausgebildet werden, die isolierend in einer Richtung und leitend in einer anderen Richtung ist.

Vorteilhafte Ausgestaltungen sind in den Unteransprüchen bezeichnet.

Vorzugsweise kann vorgesehen sein, daß die Rasterweite D im Bereich von 1 $\mu$m bis 500 $\mu$m gewählt wird, bevorzugt im Bereich von 5 $\mu$m bis 300 $\mu$m gewählt wird. Es kann auch vorgesehen sein, daß die Rasterweite im Bereich von 10 $\mu$m bis 250 $\mu$m liegt. Wenn die Rasterweite D in diesen Bereichen liegt, werden einerseits auffällige Beugungseffekte des Mehrschichtkörpers vermieden und andererseits sind die Musterbereiche im einzelnen nicht sichtbar, da die Unterteilung unterhalb der Auflösungsgrenze des unbewaffneten menschlichen Auges liegt.

Weiter kann vorgesehen sein, daß das Verhältnis der Rasterweite D zum Abstand B im Bereich von 5 bis 200 gewählt wird. Mit dem Verhältnis D/B kann insbesondere die elektrische Durchschlagsfestigkeit des Mehrschichtkörpers beeinflußt werden.

. Es ist vorgesehen, daß die metallische Schicht auf eine von der Replizierschicht aufgespannte Ebene vollflächig in einer konstanten Flächendichte aufgebracht, vorzugsweise aufgedampft wird. Ein solches Verfahren ist kostengünstig und in der Schichtdicke der metallischen Schicht gut steuerbar.

In einer vorteilhaften Ausgestaltung ist vorgesehen, daß die metallische Schicht auf die Replizierschicht vollflächig in einer Dicke aufgebracht wird, bei der die metallische Schicht in einem Bereich der Replizierschicht ohne Oberflächenstruktur eine optische Dichte zwischen 1 und 7 besitzt. Der Effekt der unterschiedlichen Transmission, insbesondere Transparenz wird durch das weiter unten näher beschriebene Tiefen-zu-Breiten-Verhältnis der Oberflächenstruktur der Replizierschicht eingestellt. Bei der metallischen Schicht kann es sich um ein Metall, beispielsweise um Aluminium, Silber, Gold, Kupfer, Chrom oder Palladium oder um eine Legierung aus diesen und/oder weiteren Metallen handeln oder um eine Schichtfolge der oben aufgeführten Metalle.

Es kann weiter vorgesehen sein, daß in dem zweiten Bereich eine zweite Oberflächenstruktur in der Replizierschicht abgeformt ist und daß als erste diffraktive Oberflächenstruktur eine Oberflächenstruktur in die Replizierschicht abgeformt wird, die die Transmission, insbesondere die Transparenz der metallischen Schicht im ersten Bereich gegenüber der Transmission, insbesondere der Transparenz der metallischen Schicht in dem zweiten Bereich erhöht, oder umgekehrt. Auf diese Weise kann also mittels der Oberflächenstruktur in der Replizierschicht die Transmission, insbesondere die Transparenz, bzw. die optische Dichte der metallischen Schicht beeinflußt werden. Bereits geringe Unterschiede in der Transmission oder Transparenz, die beispielsweise durch das menschliche Auge nicht mehr wahrnehmbar sind, können bei geeigneten Fertigungsbedingungen ausreichend sein, um die metallische Schicht als Belichtungsmaske zu verwenden. Weil die Replizierschicht kostengünstig mit einer sehr feinen Oberflächenstruktur ausgebildet werden kann, lassen sich die geforderten hohen Auflösungen bei der Teildemetallisierung der metallischen Schicht ebenso kostengünstig ausführen.

Es kann vorgesehen sein, daß die erste Oberflächenstruktur eine größere Relieftiefe als die zweite Oberflächenstruktur besitzt oder umgekehrt.

In einer weiteren Ausführung kann vorgesehen sein, daß das Produkt aus Spatialfrequenz und Relieftiefe der ersten Oberflächenstruktur größer als das Produkt aus Spatialfrequenz und Relieftiefe der zweiten Oberflächenstruktur ist oder umgekehrt. Die Spatialfrequenz wird in Linien/mm angegeben und ist ein kennzeichnendes Merkmal für diffraktive Strukturen. Bei der bevorzugten Rasterweite von 5 $\mu$m bis 300 $\mu$m ist sie vorteilhafterweise zwischen 500 Linien/mm und 5000 Linien/mm gewählt. Bei Strukturen mit stochastischem Profil, wie beispielsweise Mattstrukturen, wird als Kenngröße eine typische Distanz zwischen Erhebungen verwendet oder beispielsweise die sogenannte Korrelationslänge. Diese Kenngröße liegt analog zwischen 0,2 und 2,0 μm.

Es kann vorgesehen sein, daß in dem ersten Bereich als erste diffraktive Oberflächenstruktur eine Oberflächenstruktur mit einem hohem Tiefen-zu-Breiten-Verhältnis der einzelnen Strukturelemente, insbesondere mit einem Tiefen-zu-Breiten-Verhältnis > 0,3, abgeformt wird und daß die zweite Oberflächenstruktur als Oberflächenstruktur mit niedrigerem Tiefen-zu-Breiten-Verhältnis ausgebildet wird, oder umgekehrt.

Das dimensionslose Tiefen-zu-Breiten-Verhältnis, häufig auch als Aspektrate bezeichnet, ist ein kennzeichnendes Merkmal für die Oberflächenvergrößerung durch vorzugsweise periodische Strukturen. Eine solche Struktur bildet in periodischer Abfolge "Berge" und "Täler" aus. Als Tiefe ist hier der Abstand zwischen "Berg" und "Tal" bezeichnet, als Breite der Abstand zwischen zwei "Bergen". Je höher nun das Tiefen-zu-Breiten-Verhältnis ist, desto steiler sind die "Bergflanken" ausgebildet und desto dünner ist eine auf den "Bergflanken" abgeschiedene metallische Schicht ausgebildet. Dieser Effekt ist auch zu beobachten, wenn es sich um diskret verteilte "Täler" handelt, die in einem Abstand zueinander angeordnet sein können, der um ein Vielfaches größer als die Tiefe der "Täler" ist. In einem solchen Fall ist die Tiefe des "Tales" zur Breite des "Tales" ins Verhältnis zu setzen, um durch Angabe des Tiefen-zu-Breiten-Verhältnisses die Geometrie des "Tales" zutreffend zu beschreiben.

Es ist also möglich, mit Hilfe des Tiefen-zu-Breiten-Verhältnisses die effektive Dicke der metallischen Schicht im Bereich der Oberflächenstruktur einzustellen.

Weitere vorteilhafte Ausführungen sind auf die Gestaltung der Belichtung und Entwicklung der photoempfindlichen Schichten sowie auf das Ätzen der metallischen Schicht gerichtet.

Es kann vorgesehen sein, daß als photoempfindliche Schicht oder als photoempfindliche Waschmaske ein photoempfindliches Material mit einer binären Charakteristik aufgebracht wird und daß die photoempfindliche Schicht bzw. die photoempfindliche Waschmaske durch die metallische Schicht hindurch in einer Belichtungsstärke und Belichtungsdauer belichtet wird, daß die photoempfindliche Schicht bzw. die photoempfindliche Waschmaske im ersten Bereich oder im zweiten Bereich, in dem die Transmission, insbesondere die Transparenz der metallischen Schicht durch die erste Oberflächenstruktur bedingt erhöht ist, aktiviert wird und im zweiten Bereich nicht aktiviert wird, oder umgekehrt.

Dabei kann vorgesehen sein, daß die photoempfindliche Schicht bzw. Waschmaske durch die metallische Schicht hindurch mittels UV-Strahlung belichtet wird. UV-Strahlung ist energiereicher als Tageslicht und deshalb vielfach bevorzugt.

Anschließend können die durch die Belichtung aktivierten Bereiche der photoempfindlichen Waschmaske und die darauf angeordneten Bereiche der metallischen Schicht in einem Waschprozeß entfernt werden.

Es kann aber auch vorgesehen sein, daß die belichtete photoempfindliche Schicht entwickelt wird und daß die entwickelte photoempfindliche Schicht eine Ätzmaske für die metallische Schicht bildet.

Eine weitere vorteilhafte Ausgestaltung sieht vor, daß die photoempfindliche Schicht durch die Belichtung im ersten Bereich, in dem die Transmission, insbesondere die Transparenz der metallischen Schicht durch die erste Oberflächenstruktur erhöht ist, aktiviert wird, und daß die aktivierte photoaktivierbare Schicht ein Ätzmittel für die metallische Schicht bildet.

Es kann vorgesehen sein, daß die photoempfindliche Schicht aus einem Photoresist ausgebildet wird.

Der Photoresist kann als positiver Photoresist oder als negativer Photoresist ausgebildet werden.

Bei der photoempfindlichen Schicht kann es sich auch um ein Photopolymer handeln.

Es kann weiter vorgesehen sein, daß die Überreste der Ätzmasken entfernt werden.

Ein möglicher Ausgangspunkt zur Herstellung des teilmetallisierten Mehrschichtkörpers ist also die metallische Schicht, welche mit einem Photoresist beschichtet ist. Die Strukturierung erfolgt typischerweise, wie oben beschrieben, durch Belichtung des Photoresists, Entwickeln bzw. Ätzen des Photoresists und Ätzen der metallischen Schicht mit dem Photoresist als Ätzmaske. Die Belichtung des Photoresists kann beispielsweise erfolgen durch:

- einen Bandbelichter; dabei wird eine bandförmige Belichtungsmaske in Kontakt mit dem Mehrschichtkörper transportiert und durch die Maske hindurch der Photoresist auf dem Mehrschichtkörper belichtet;
- angesteuertes Belichten mit einem fokussierten Laserstrahl, d.h. ein Laserstrahl wird durch eine Ansteuereinheit mittels einer Ablenkeinheit und ggf. einer Fokussieroptik über den Mehrschichtkörper bewegt;
- eine Maske, welche über eine Abbildungsoptik auf den Mehrschichtkörper projiziert wird. Das Verfahren kann im Sinne von "step & repeat" sein oder mittels einer im Register angesteuerten Blitzlampe erfolgen. Zudem kann die Maske elektronisch gesteuert und variabel sein, beispielsweise ein "spatial light modulator".

Vorteilhafterweise erfolgt die Belichtung jeweils auf die Photoresistseite, sie kann jedoch auch durch die metallische Schicht hindurch erfolgen.

Weiterhin kann die Strukturierung auch durch direkte Laserbestrahlung (Ablation) erfolgen, ohne den Umweg mittels Photoresist als "verstärker". Dabei kann unmittelbar das unterschiedliche Absorptionsverhalten der metallischen Schicht in Bereichen mit unterschiedlichen Oberflächenstrukturen bzw. in Bereichen mit und ohne Oberflächenstrukturen ausgenutzt werden.

Weiterhin kann die Strukturierung durch Ausnutzung des strukturabhängigen Ätzverhaltens der metallischen Schicht erfolgen. Werden nämlich strukturierte Oberflächen mit einer metallischen Schicht bedampft und einem geeigneten Ätzmedium ausgesetzt, so erscheinen Bereiche mit hohem Aspektverhältnis nach einer bestimmten Zeit transparent, währenddem unstrukturierte Bereiche oder Bereiche mit geringem Aspektverhältnis immer noch weitgehend opak erscheinen. Ein derart zeitgesteuerter Ätzprozess endet beispielsweise dann, wenn in Bereichen der Replizierschicht mit Oberflächenreliefstruktur und effektiv dünnerer Schichtdicke der metallischen Schicht Transparenz erzeugt wurde, während in Bereichen der Replizierschicht ohne Oberflächenstruktur und effektiv dickerer Schichtdicke der metallischen Schicht noch eine opake metallische Schicht vorliegt. Die auch in den unstrukturierten Bereichen auftretende Ätzung der metallischen Schicht wird üblicherweise durch eine zu Beginn erhöhte optische Dichte der aufgedampften metallischen Schicht vorkompensiert. Als Anwendungsfall kann beispielsweise die Ausbildung eines Handygehäuses vorgesehen sein.

Weiter kann die Kombination mit klassischen Demetallisierungsverfahren vorgesehen sein. Es kann also vorgesehen sein, daß weitere Bereiche durch klassische Demetallisierung vollständig oder partiell demetallisiert werden.

Weiter können eine oder mehrere Schichten des Mehrschichtkörpers, beispielsweise der Transferlage der Transferfolie, eingefärbt sein, um einen visuellen Eindruck zu erzeugen. Dabei kann der Mehrschichtkörper neben der metallischen Schicht weiterhin mindestens eine vollflächig oder partiell ausgebildete transparente oder opake farbige Schicht umfassen. Besonders bevorzugt ist es dabei, wenn die mindestens eine farbige Schicht im Register zu der metallischen Schicht ausgebildet ist, insbesondere in dem von der metallischen Schicht freien ersten oder zweiten Bereich angeordnet ist. Dadurch lässt sich ein farbiger Eindruck erzielen und/oder der Mehrschichtkörper trotz der Teilmetallisierung opak ausgebildet werden. Insbesondere ist es bevorzugt, wenn die mindestens eine farbige Schicht in dem von der metallischen Schicht freien ersten oder zweiten Bereich angeordnet ist und weiterhin eine zur metallischen Schicht ähnliche Farbe aufweist. So ist bei einer silbernen metallischen Schicht eine graue oder bei einer goldenen metallischen Schicht einen gelbliche Schicht bevorzugt, welche dazu beiträgt, dem menschlichen Auge eine ohne Unterbrechungen vorliegende spiegelnde metallische Schicht zu suggerieren.

Dabei hat es sich weiterhin bewährt, wenn die mindestens eine farbige Schicht entweder als eine elektrisch leitfähige Schicht, welche beispielsweise nicht-metallische elektrisch leitende Stoffe, wie Kohlenstoff oder Polymere enthält, oder als eine elektrisch isolierende Schicht, welche beispielsweise die Durchschlagsspannung erhöht, ausgebildet ist. Die mindestens eine farbige Schicht kann schließlich auch eine halbleitende Schicht sein. Vorzugsweise enthält die mindestens eine farbige Schicht kein Metall.

Insbesondere hat es sich bewährt, wenn mindestens zwei, insbesondere mindestens drei farbige Schichten in unterschiedlicher Farbe ausgebildet sind. Vorzugsweise erfolgt eine Auswahl aus dem Farbsystem CMYK.

Es können aber auch Farbstoffe eingesetzt werden, welche nur in einem bestimmten Wellenlängenbereich opak oder transparent sind und beispielsweise bei der Belichtung mit UV-Licht als Filter wirken. Dadurch lassen sich mittels Druck zusätzliche lokale Strukturierungen der Leitfähigkeit erzielen, welche zudem durch die Wahl des Spektrums der Lichtquelle beeinflußt werden können.

In einer weiteren vorteilhaften Ausgestaltung ist vorgesehen, daß die metallische Schicht galvanisch verstärkt wird. Dabei ist es auch möglich, die Schicht durch ein zweites Metall oder eine Metallegierung zu verstärken. Nach dem Belichten wird der Photoresist partiell entfernt, so daß entsprechend metallische Bereiche der metallischen Schicht freigelegt sind. Der galvanische Aufbau erfolgt nun in den freigelegten Bereichen, währenddem die mit Photoresist bedeckten Bereiche im wesentlichen dazu dienen, die für den galvanischen Aufbau notwendige elektrische Leitfähigkeit sicherzustellen. Anschließend wird der Photoresist auch von diesen Bereichen entfernt. Die verbliebene dünne metallische Schicht im Hintergrundbereich wird anschließend durch Ätzen entfernt.

Für den erfindungsgemäßen Mehrschichtkörper kann vorgesehen sein, daß der Raster mit konstanter Rasterweite D ausgebildet ist.

In einer weiteren Ausführung kann vorgesehen sein, daß der Raster mit nichtkonstanter Rasterweite D ausgebildet ist.

Weiter kann vorgesehen sein, daß die Rasterweite D vorzugsweise in einem Bereich von $\pm$ 40 % zufallsverteilt variiert. Mit einer solchen zufallsverteilten Variation der Rasterweite kann dem Auftreten von Moiré entgegengewirkt werden, sowie Beugungseffekte vermieden werden, welche sich bei Rastern mit konstanter Rasterweite u.U. störend bemerkbar machen können.

Es kann aber auch die Ausbildung eines Moiré-Effekts vorgesehen sein, wenn damit eine besondere optische Wirkung erzielt werden soll.

Die erste oder zweite Oberflächenstruktur kann als optisch aktive, reflektierende oder transmittierende lichtbeugende und/oder lichtbrechende und/oder lichtstreuende Mikro- oder Nanostruktur ausgebildet sein, beispielsweise als Gitterstruktur, wie Lineargitter oder Kreuzgitter, als Überlagerung mehrerer Gitterstrukturen, als isotrope oder anisotrope Mattstruktur, als binäre oder kontinuierliche Fresnellinse, als Mikroprisma, als Blazegitter, als Kombinationsstruktur oder als Makrostruktur. Auf diese Weise lassen sich zahlreiche interessante optische Effekte ausbilden. Es ist also möglich, ein metallisch erscheinendes Hologramm oder KINEGRAM® elektrisch nichtleitend auszubilden. Das Reflexionsvermögen wird durch die Teildemetallisierung nur geringfügig vermindert, so daß das Hologramm im wesentlichen in gleicher Intensität wahrgenommen wird, wie eine elektrisch leitende Version. Da die Rasterung unterhalb der Auflösungsgrenze des unbewaffneten Auges liegt, bleibt sie dem menschlichen Betrachter verborgen, sofern die Rasterung derart gewählt wird, daß keine Moiré-Effekte mit Designelementen des Hologramms auftreten. Auch bei maschineller Auswertung sind keine Qualitätseinbußen zu befürchten.

Durch lokale Variation der Rasterung kann das Transmissionsverhalten der nichtleitenden Spiegelfolie deutlich erkennbar verändert werden, währenddem das Reflexionsverhalten nur unmerklich variiert. In Betrachtung im Auflicht ist somit keine Information erkennbar, während sie sich bei Betrachtung im Durchlicht beispielsweise als bildhafte Darstellung erschließt.

Weiter kann vorgesehen sein, daß der Mehrschichtkörper eine zweite metallische Schicht aufweist, die im Register zu einer ersten metallischen Schicht und/oder zur mindestens einen farbigen Schicht angeordnet ist.
Damit lassen sich weitere interessante Effekte ausbilden.

Die metallischen Schichten können unterschiedliche Dicken aufweisen, wodurch zum einen die elektrischen Eigenschaften des Mehrschichtkörpers und zum anderen die optischen Eigenschaften des Mehrschichtkörpers weiter gestaltbar sind.

So kann vorgesehen sein, daß mindestens eine der metallischen Schichten in einer Schichtdicke aufgebracht ist, bei der sie im sichtbaren Bereich teilweise transparent ist. Die dafür zu wählende Schichtdicke ist materialabhängig. Schichtdicken von einigen 10 nm können bereits opak, d.h. nichttransparent erscheinen. Beispielsweise erscheint Aluminium opak, wenn seine optische Dichte im Bereich von 1 bis 5 liegt. Sie wird weiter durch das Tiefen-zu-Breiten-Verhältnis der Oberflächenstruktur der Replizierschicht bestimmt, auf der die metallische Schicht abgeschieden ist.

Trotz der optischen Transparenz kann die metallische Schicht noch eine elektrische Leitfähigkeit aufweisen, die für viele Anwendungsfälle ausreichend ist. Es kann beispielsweise vorgesehen sein, einen solchen als Folie ausgebildeten Mehrschichtkörper zur Abschirmung elektromagnetischer Strahlung zu verwenden oder zur Ableitung statischer elektrischer Aufladungen. Der Mehrschichtkörper kann also u.a. als Verpackungsfolie für gegen statische Aufladung empfindliche Bauelemente, wie beispielsweise Mikroprozessoren, eingesetzt werden. Es kann auch vorgesehen sein, daß eine solche Folie nur mit einer metallischen Schicht ausgebildet ist, wie weiter oben beschrieben.

Weiter kann vorgesehen sein, daß der Abstand zwischen den metallischen Schichten so gewählt ist, daß Interferenzeffekte auftreten. Dazu können die metallischen Schichten im $(2n+1)\cdot\lambda/2$- oder $(4n+1)\cdot\lambda/4$-Abstand angeordnet sein, wobei $n$ eine ganze Zahl incl. 0 ist und $\lambda$ die Wellenlänge des Lichtes bezeichnet. Durch die Interferenz an dünnen Schichten werden Farbwechsel erzeugt, wie sie beispielsweise von Ölfilmen auf Wasseroberflächen bekannt sind. Auf diese Weise können interessante optische Effekte ausgebildet werden, die beispielsweise dekorativen Zwecken dienen können oder ein schwer nachahmbares Sicherheitsmerkmal bilden können.

Weitere vorteilhafte Ausgestaltungen sind auf die Gestaltung der Oberflächenstruktur gerichtet, die die Ausbildung weiterer optischer Effekte ermöglichen.

Es kann vorgesehen sein, daß die metallischen Schichten eine unterschiedliche erste Oberflächenstruktur und/oder zweite Oberflächenstruktur aufweisen und/oder daß ihre ersten Bereiche und/oder ihre zweiten Bereiche unterschiedlich angeordnet sind. Die Musterbereiche der beiden metallischen Schichten können beispielsweise schachbrettartig gegeneinander versetzt angeordnet sein und mit farblich unterschiedlichen Metallen ausgeführt sein, beispielsweise Aluminium und Kupfer. Dabei können die Musterbereiche einer Schicht auch Gruppen bilden, die auf Grund ihrer Abmessungen durch das menschliche Auge wahrgenommen werden können. Bei den Gruppen könnte es sich beispielsweise um Bildpunkte handeln, die insgesamt zu einer bildlichen oder textlichen Darstellung angeordnet sind.

Weiter kann vorgesehen sein, daß es sich bei der ersten Oberflächenstruktur und/oder der zweiten Oberflächenstruktur um eine beugungsoptische Oberflächenstruktur handelt, beispielsweise ein Hologramm, Kinegram® oder dergleichen. Auf diese Weise kann beispielsweise ein metallisiertes Hologramm oder Kinegram® mit einer elektrisch nichtleitenden Oberfläche oder Reflexionsschicht versehen werden. Es kann deshalb als Sicherheitsmerkmal auf Lebensmittelverpackungen angebracht werden, die samt Inhalt in einer Mikrowelle der Mikrowellenstrahlung ausgesetzt werden sollen. Es ist aber auch möglich, solche Sicherheitsmerkmale auf Geldscheinen oder Dokumenten anzubringen und die Echtheitsprüfung durch Mikrowellenbestrahlung vorzunehmen. Auf diese Weise können nachgeahmte Sicherheitsmerkmale identifiziert und gleichzeitig zerstört werden.

Weiter kann vorgesehen sein, daß es sich bei der ersten Oberflächenstruktur und/oder bei der zweiten Oberflächenstruktur um eine Mattstruktur handelt. Weiter oben ist dargestellt, daß sich mit dem erfindungsgemäßen Verfahren Spiegelfolien herstellen lassen, die eine elektrisch nichtleitende Oberfläche aufweisen. Die Oberflächenstruktur der inselförmigen metallisierten Bereiche kann jedoch auch als Mattstruktur ausgebildet sein oder in einer anderen Weise gestaltet sein, um den vielfältigen optischen Eindruck metallischer Oberflächen nachzuahmen, beispielsweise von gebürsteten Oberflächen mit mattem Metallglanz. Die metallische Reflexionsschicht kann auch mit weiteren transparenten oder eingefärbten Schichten überdeckt sein.

In einer weiteren vorteilhaften Ausgestaltung kann der Musterbereich und/oder der Hintergrundbereich in Form eines Mikrotexts oder einer Mikrografik substrukturiert sein. Der Mikrotext oder die Mikrografik können ein Sicherheitsmerkmal bilden, das mit dem unbewaffneten menschlichen Auge nicht wahrnehmbar ist und das nur schwer nachahmbar ist.

Der Mikrotext oder die Mikrografik oder ein Barcode können als metallisierte oder als nichtmetallisierte Subbereiche ausgebildet sein. In einem metallisierten Musterbereich können also beispielsweise nichtmetallisierte Subbereiche ausgebildet sein, indem dort eine andere Oberflächenstruktur in die Replizierschicht abgeformt ist als in den Musterbereich selbst. Die Hüllkurve der anderen Oberflächenstruktur bildet dabei die Randkontur des Mikrotextes oder der Mikrografik. Es kann sich aber auch um einen metallisierten Subbereich handeln, der sich in seiner optischen Wirkung von dem ihn umgebenden Musterbereich unterscheidet, also beispielsweise durch Farbwechsel beim Neigen oder Kippen der Folie in Erscheinung tritt. In analoger Weise kann Mikrotext oder Mikrografik in den Hintergrundbereich eingebracht sein, wobei vorteilhafterweise vorgesehen sein kann, daß metallisierter Mikrotext oder Mikrografik durch nichtmetallisierte Bereiche von den metallisierten Musterbereichen getrennt sind, wenn die Folie mit nichtleitender Oberfläche ausgebildet sein soll.

Weiter kann vorgesehen sein, daß die Musterbereiche und/oder der Hintergrundbereich in Form eines versteckten Musters substrukturiert sind, das durch einen Moiré-Verifier, also ein separates Verifizierungsschild, erschließbar ist. Auch ein solches Sicherheitsmerkmal ist nur schwer nachzuahmen.

Weitere mögliche Anwendungsfälle des erfindungsgemäßen Mehrschichtkörpers außer den weiter oben beschriebenen können sein:

- OLED,
- Sensorik, beispielsweise Sensoren mit sensitiven Schichten, welche empfindlich auf Feuchtigkeit, Sauerstoff, Licht, Hitze, Kälte, usw. reagieren,
- Sicherheitselemente mit leitfähiger Strukturierung, welche mittels Detektor überprüfbar sind,
- Leiterplatten,
- elektronische Bauelemente.

Dazu können weitere, gegebenenfalls lediglich partiell ausgeformte, funktionelle Schichten, wie Halbleiterschichten, Isolatorschichten, sensitive Schichten oder ähnliches, im Mehrschichtkörper vorgesehen sein, die optische und/oder elektrische Eigenschaften aufweisen.

Zahlreiche weitere Applikationen und/oder Zusatzeffekte sind möglich, wie beispielsweise:

- Realisierung spezieller Testpunkte auf der Oberfläche des Mehrschichtkörpers, welche die Überprüfung der elektrischen Leitfähigkeit erlauben,
- Dickenvariation der metallischen Schicht,
- Belichtung mit polarisiertem Licht,
- frequenzabhängige Auslegung der Parameter der teilmetallisierten Bereiche,
- Ergänzung des mit strukturierter elektrischer Leitfähigkeit ausgebildeten Mehrschichtkörpers durch weitere elektronische Bauelemente.

Im folgenden wird die Erfindung anhand von mehreren Ausführungsbeispielen unter Zuhilfenahme der beiliegenden Zeichnungen beispielhaft verdeutlicht. Es zeigen

Fig. 1   eine schematische Schnittdarstellung eines ersten Ausführungsbeispiels;
Fig. 2   eine schematische Darstellung des ersten Ausführungsbeispiels in der Draufsicht;
Fig. 3   eine schematische Darstellung eines zweiten Ausführungsbeispiels in der Draufsicht;
Fig. 4   eine schematische Darstellung eines dritten Ausführungsbeispiels in der Draufsicht;
Fig. 5   eine schematische Darstellung eines vierten Ausführungsbeispiels in der Draufsicht;
Fig. 6   eine schematische Schnittdarstellung eines fünften Ausführungsbeispiels;
Fig. 7   eine schematische Darstellung eines sechsten Ausführungsbeispiels in der Draufsicht;
Fig. 8   eine Fertigungsstufe des ersten Ausführungsbeispiels in schematischer Schnittdarstellung;
Fig. 9   eine weitere Fertigungsstufe gemäß Fig. 8;
Fig. 10   die letzte Fertigungsstufe gemäß Fig. 8;
Fig. 11   eine schematische Darstellung eines siebenten Ausführungsbeispiels in der Draufsicht.

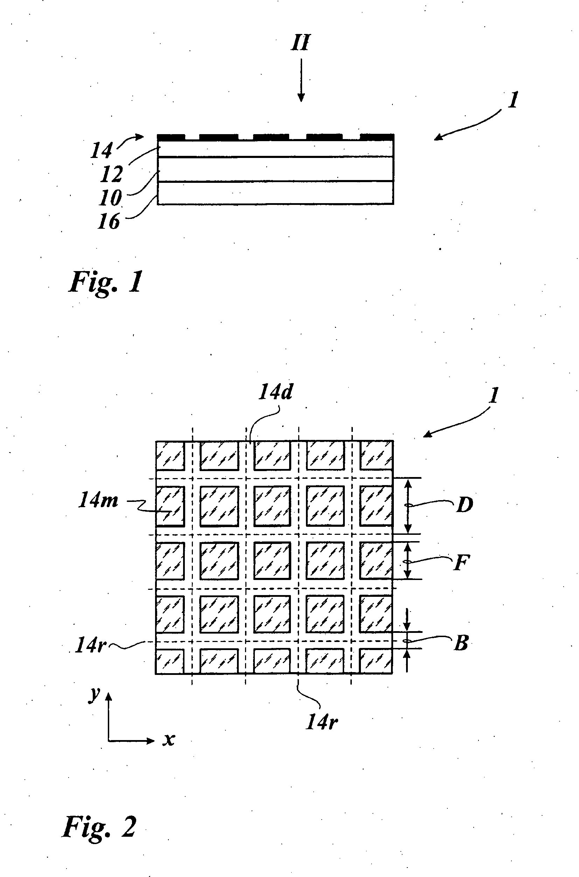

Fig. 1 zeigt einen Mehrschichtkörper als einen mehrschichtigen Folienkörper 1, bei dem es sich um eine Heißprägefolie handeln kann. Auf eine Trägerfolie 10, die aus einer etwa 20 µm starken Polyesterfolie gebildet sein kann, ist eine Replizierschicht 12 aufgebracht. Bei der Replizierschicht 12 kann es sich um eine thermoplastische Schicht handeln, in die mittels eines Replizierwerkzeuges ein Muster abgeformt ist. Es kann sich aber auch um einen UV-härtenden Lack handeln, bei dem das Muster durch Maskenbelichtung mittels UV-Licht eingebracht ist oder durch Abformung ab einer Vorlage mit Oberflächenstruktur erfolgt.

Die Replizierschicht 12 trägt eine teilweise durchbrochene metallische Schicht 14, die beispielsweise aus Aluminium, Kupfer, Silber, Gold oder Chrom bestehen kann. Als letzte Schicht ist auf der der Replizierschicht 12 abgewandten Seite der Trägerfolie 10 eine Kleberschicht 16 aufgetragen, mit deren Hilfe der Folienkörper 1 auf ein Substrat übertragen werden kann. Bei der Kleberschicht 16 kann es sich vorzugsweise um einen Heißkleber handeln.

Als weitere Variante kann die Kleberschicht 16 auch auf die Metallschicht aufgebracht sein. Insbesondere kann der Verbund aus Replizierschicht, Metallschicht und Kleberschicht als Transferlage ausgestaltet sein, welche auf ein Substrat aufgeklebt wird, wobei der Träger 10 anschließend abgezogen werden kann.

Fig. 2 zeigt nun im Detail die Ausbildung der metallischen Schicht 14 in der Draufsicht. Die metallische Schicht 14 ist in inselförmige Bereiche 14m aufgegliedert, die jeweils von demetallisierten Bereichen 14d der Replizierschicht 12 mit einer Breite B umschlossen sind. Die demetallisierten Bereiche 14d bilden einen zusammenhängenden Hintergrundbereich. Die Bereiche 14m sind in einem Raster mit einer Rasterweite D angeordnet, wobei die Rasterlinien mit Position 14r bezeichnet sind. Sie sind in dem in Fig. 2 dargestellten Ausführungsbeispiel als quadratische Felder mit einer Kantenlänge F ausgebildet, die kleiner als die Rasterweite D ist:

$$F = D - B$$

Die Rasterweite D und das Verhältnis der Rasterweite D zur Breite B sind nun so gewählt, daß die Strukturierung der metallischen Schicht 14 durch ein unbewaffnetes menschliches Auge nicht sichtbar ist. Dabei sind folgende Randbedingungen zu beachten:

- Der kleinste zulässige Wert für das Verhältnis der Rasterweite D zur Breite B ist durch die maximal auftretende elektrische Überschlagsspannung bestimmt, wobei zu berücksichtigen ist, daß äußere Einflüsse, wie Luftfeuchtigkeit, Handschweiß und Verschmutzung die Isolationswirkung der demetallisierten Bereiche 14d herabsetzen können. Zudem wird die Überschlagsspannung durch allfällige absichtlich aufgebrachte dielektrische Deckschichten bestimmt. Diese Deckschichten können aus Teilen der Folie 1 bestehen, wie beispielsweise Replizierschicht oder Kleber.
- Der kleinste zulässige Wert für die Rasterweite D ist durch Beugungseffekte begrenzt, die an Strukturen in der Größenordnung der Lichtwellenlänge auftreten können und den Eindruck einer geschlossenen metallischen Oberfläche zerstören, respektive ungewünschte Farbeffekte erzeugen.
- Der größte zulässige Wert für die Breite B und/oder die Rasterweite D ist durch das Auflösungsvermögen des menschlichen Auges begrenzt. Werden Rasterweite D und/oder Breite B zu groß gewählt, kann die Rasterung vom unbewaffneten Auge erkannt werden.

Die metallisierten Bereiche 14m können als spiegelnde Flächen ausgebildet sein, so daß der Folienkörper 1 als Spiegelfolie erscheint. Es können aber auch beugungsoptische Strukturen in die Bereiche 14m eingebracht sein, beispielsweise ein Hologramm, oder es können Mattstrukturen ausgebildet sein. Auf diese Weise können vielfältige optische Effekte erzeugt werden, die über die Nachbildung einer optisch einheitlichen metallischen Oberfläche hinausgehen. Beispielsweise können "metallische" mikrowellentaugliche Sicherheitsmerkmale, Logos oder Beschriftungen auf Verpackungen für Fertigmahlzeiten angebracht werden, die beim Erhitzen in der Mikrowelle nicht zerstört werden, weil es sich um elektrisch nichtleitende metallische Oberflächen handelt. Sicherheitselemente, wie sie auf Dokumenten und Geldscheinen verwendet werden, können auf diese Weise mit einem zusätzlichen Sicherheitsmerkmal ausgestattet werden, das darin besteht, daß ein solches Sicherheitselement durch Mikrowellenstrahlung nicht zerstörbar ist. Weiter können elektronische Geräte, wie Fernsehempfänger, mit einer elektrisch nichtleitenden metallischen Oberfläche versehen werden. Die Metallschicht muß dabei nicht an der physischen Oberfläche zu liegen kommen, sondern kann auch zwischen dielektrischen Schichten eingebettet sein, beispielsweise als Teil einer Transferlage oder durch Spritzguß bei der Herstellung der Gehäusekomponenten.

Wenngleich es sich bei dem Raster des in Fig. 2 dargestellten Ausführungsbeispiels um ein quadratisches Raster handelt, dessen Rasterweite D in den Koordinatenrichtungen x und y gleich ist, kann aber auch vorgesehen sein, daß die Rasterweite D in Richtung der x-Koordinate und der y-Koordinate unterschiedlich ist. Ebenso kann die Kantenlänge F des metallisierten Bereiches 14m und/oder die Breite B des demetallisierten Bereiches 14d unterschiedlich ausgebildet sein. Bei den metallisierten Bereichen 14m kann es sich auch um rechteckige, kreisförmige, elliptische oder sonstig geformte Bereiche mit geschlossener Kontur handeln. Bei einem quadratischen Raster, wie in Fig. 2 dargestellt, können Quadrate, Kreise und regelmäßige Vielecke als Kontur der metallisierten Bereiche bevorzugt sein.

Es kann auch vorgesehen sein, linienförmige metallisierte Bereiche 14m auszubilden, die durch linienförmige demetallisierte Bereiche 14d voneinander getrennt sind. Die metallisierten Bereiche 14m sind demzufolge in einem Linienraster angeordnet, d.h. in einem eindimensionalen Raster. Ein solcher Folienkörper ist folglich in senkrecht zu den linienförmigen Bereichen 14m, 14d verlaufender Richtung isolierend und in parallel zu den linienförmigen Bereichen 14m, 14d verlaufender Richtung leitfähig ausgebildet.

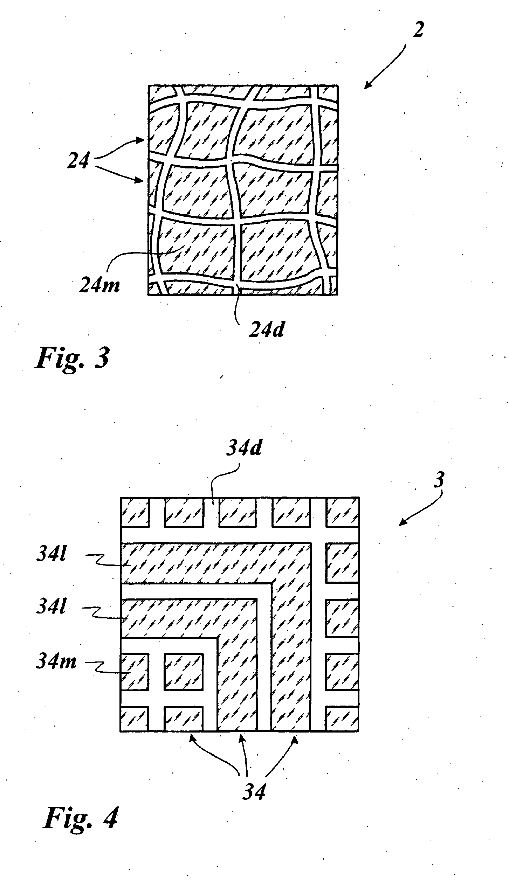

Fig. 3 zeigt nun ein zweites Ausführungsbeispiel, bei dem die Rasterweite in zufälliger Weise um $\pm$ 40 % um den Wert $D_0$ variiert. Es handelt sich in Fig. 3 um einen in der Draufsicht dargestellten Folienkörper 2, bei dem sowohl die metallisierten Bereiche 14m als auch die demetallisierten Bereiche 14d unregelmäßig geformt ausgebildet sind, wobei die Abweichungen von einem quadratischen Raster nicht größer als 40 % sind. Mit einer solchen Ausführung können beispielsweise das Auftreten von Moiré-Effekten oder störende Beugungseffekte vermieden werden.

Fig. 4 zeigt eine schematische Darstellung eines dritten Ausführungsbeispiels, das durch Variation des ersten Ausführungsbeispiels in Fig. 2 gebildet ist.

Eine metallische Schicht 34 ist nun so strukturiert, daß neben voneinander isolierten metallisierten Bereichen 34m Bereiche der metallischen Schicht 34 miteinander verbunden sind und so Leiterbahnen 34l bilden. Auf diese Weise können beispielsweise Antennen ausgebildet werden, die für das unbewaffnete menschliche Auge nicht sichtbar sind. Weil die unter den metallisierten Bereichen 34m, 34l angeordnete Replizierschicht eine beugungsoptische Reliefstruktur aufweisen kann, beispielsweise in Form eines Hologramms, können so auch Sicherheitselemente mit elektrischen Funktionselementen versehen werden. Der Folienkörper eines solchen Sicherheitselements kann weitere Schichten aufweisen, die beispielsweise einen RFID-Tag bilden, d.h. einen Schaltkreis, der zur Identifikation mittels Radiowellen dient. Weiterhin kann der Hintergrundbereich, also zwischen den metallisierten Bereichen 34m, 34l, mit einer opaken farbigen Schicht ausgefüllt sein.

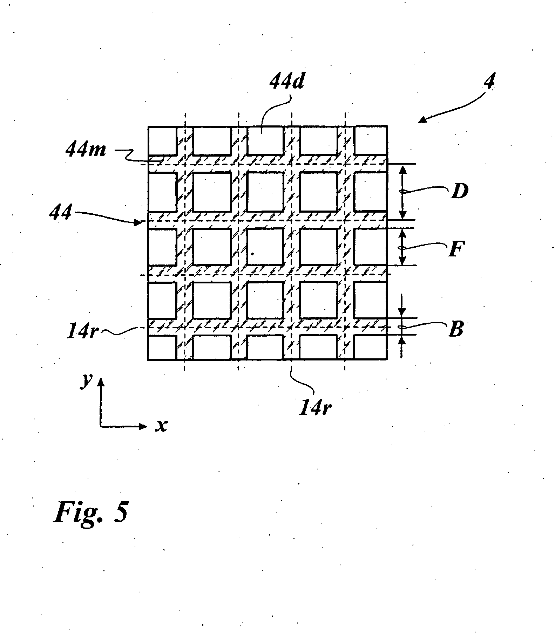

Fig. 5 zeigt nun ein viertes Ausführungsbeispiel, bei dem eine auf einen Folienkörper 4 aufgebrachte metallische Schicht 44 als weitgehend transparente elektrisch leitfähige Schicht ausgebildet ist. Im Vergleich zum ersten in Fig. 2 dargestellten Ausführungsbeispiel sind nun inselförmige demetallisierte Bereiche 44d von metallisierten streifenförmigen Bereichen 44m umgeben, die miteinander verbunden sind und auf diese Weise einen zusammenhängenden elektrisch leitenden Oberflächenbereich bilden. Dieser Oberflächenbereich hat die Form eines engmaschigen Netzes. Die metallische Schicht 44 kann beispielsweise als Abschirmung gegen elektromagnetische Felder verwendet werden oder zur Ableitung statischer Ladungen.

Es kann auch vorgesehen sein, daß auf der metallischen Schicht 44 weitere Schichten angeordnet sind, beispielsweise eine Schutzlackschicht oder eine farbige Schicht, ohne die Abschirmwirkung zu beeinträchtigen. Weiterhin kann der Folienkörper 4 in den demetallisierten Bereichen 44d eine transparente farbige Schicht im Register zu den streifenförmigen metallischen Bereichen 44m aufweisen. Zur besseren Orientierung sind in Fig. 5 die Rasterlinien 14r eingezeichnet (vergl. Fig. 2).

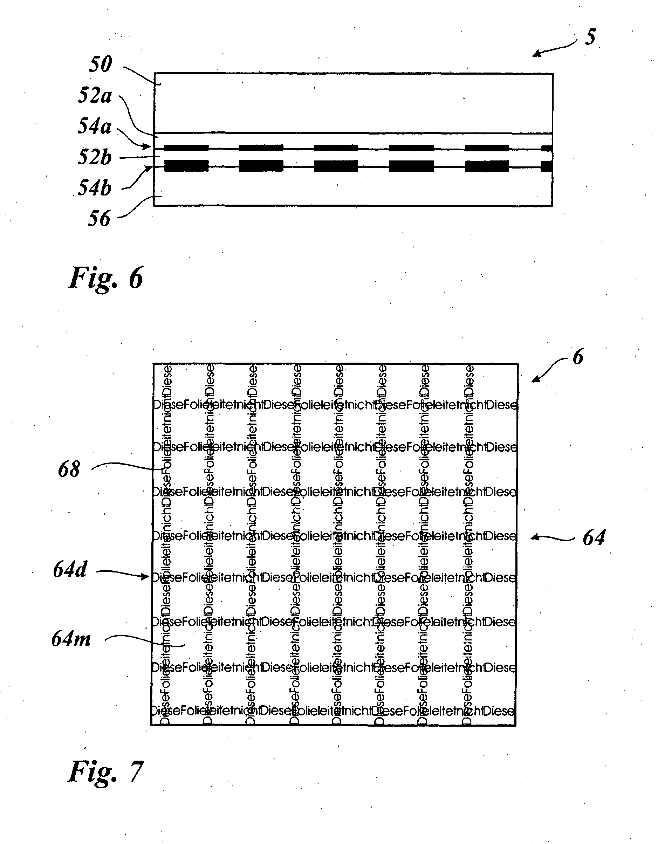

Fig. 6 zeigt nun einen Folienkörper 5, der aus einer Trägerschicht 50, einer ersten Replizierschicht 52a, einer ersten metallischen Schicht 54a, einer zweiten Replizierschicht 52b, einer zweiten metallischen Schicht 54b und einer Kleberschicht 56 besteht. Die beiden metallischen Schichten 54a und 54b sind in einem solchen Abstand voneinander angeordnet, daß die bekannten Interferenzeffekte an dünnen Schichten eintreten können. Die beiden metallischen Schichten 54a und 54b weisen weiter unterschiedliche Dicken auf. In dem in Fig. 6 dargestellten Ausführungsbeispiel ist die näher an der Trägerschicht 50 angeordnete metallische Schicht 54a die dünnere Schicht. Sie weist eine Dicke im unteren Nanometerbereich auf, so daß sie im sichtbaren Licht teilweise transparent erscheint. Weil die Transparenz einer dünnen Metallschicht u.a. materialabhängig ist, wird die erforderliche Schichtdicke zweckmäßigerweise durch eine Versuchsreihe bestimmt.

Fig. 7 zeigt einen Folienkörper 6 in der Draufsicht, bei dem die Oberfläche in der zuvor beschriebenen Art inselförmige metallisierte Bereiche 64m aufweist, die von demetallisierten Bereichen 64d umgeben sind. In den Bereichen 64d ist eine Mikrokennzeichnung eingebracht, die in dem dargestellten Ausführungsbeispiel als Mikroschrift ausgebildet ist, welche nur mit einem optischen Hilfsmittel, wie einer starken Lupe oder einem Mikroskop lesbar ist. Es können aber auch Mikrografiken vorgesehen sein. Die Mikrokennzeichnung kann jedoch die elektrische Überschlagsfestigkeit der demetallisierten Bereiche 64d vermindern, sofern sie eine metallisierte Oberfläche aufweist.

Die beschriebenen Ausführungsbeispiele schließen ein, daß die Teildemetallisierung der metallischen Schicht im Register erfolgt. Das ist ohne weiteres möglich, weil die metallische Schicht auf der Replizierschicht angeordnet ist, die mindestens bereichsweise ein Oberflächenprofil aufweist. Wenn nun auf die Replizierschicht eine metallische Schicht mit gleichmäßiger Flächendichte bezogen auf die von der Replizierschicht aufgespannte Ebene aufgebracht wird, beispielsweise durch Aufdampfen im Vakuum, so kann die Flächendichte bzw. Schichtdicke so gewählt werden, daß die aufgebrachte metallische Schicht in Abhängigkeit von dem lokalen Tiefen-zu-Breiten-Verhältnis des Oberflächenprofils eine unterschiedliche optische Dichte aufweist. Wird nun die metallische Schicht als Belichtungsmaske für einen Photoresist verwendet, d.h. der Photoresist durch die metallische Schicht hindurch belichtet, dann kann er zu einer registergenauen Ätzmaske entwickelt werden und die metallische Schicht registergenau teildemetallisiert werden.

Wenn die metallisierten Bereiche als spiegelnde Bereiche ausgebildet sein sollen, kann in die unter den demetallisierten Bereichen angeordneten Bereiche der Replizierschicht ein Oberflächenprofil mit hohem Tiefen-zu-Breiten-Verhältnis abgeformt werden, beispielsweise mit einem Tiefen-zu-Breiten-Verhältnis > 2 und die Replizierschicht unter den metallisierten Bereichen ein sehr geringes Tiefen-zu-Breiten-Verhältnis aufweisen..

Das dimensionslose Tiefen-zu-Breiten-Verhältnis, häufig auch als Aspektrate bezeichnet, ist ein kennzeichnendes Merkmal für die Oberflächenvergrößerung vorzugsweise periodischer Strukturen. Eine solche Struktur bildet in periodischer Abfolge "Berge" und "Täler" aus. Als Tiefe ist hier der Abstand zwischen "Berg" und "Tal" bezeichnet, als Breite der Abstand zwischen zwei "Bergen". Je höher nun das Tiefen-zu-Breiten-Verhältnis ist, desto steiler sind die "Bergflanken" ausgebildet und desto dünner ist eine auf den "Bergflanken" abgeschiedene metallische Schicht ausgebildet. Dieser Effekt ist auch zu beobachten, wenn es sich um diskret verteilte "Täler" handelt, die in einem Abstand zueinander angeordnet sein können, der um ein Vielfaches größer als die Tiefe der "Täler" ist. In einem solchen Fall ist die Tiefe des "Tales" zur Breite des "Tales" ins Verhältnis zu setzen, um durch Angabe des Tiefen-zu-Breiten-Verhältnisses die Geometrie des "Tales" zutreffend zu beschreiben.

Es ist also möglich, die mittlere Schichtdicke der metallischen Schicht durch das Tiefen-zu-Breiten-Verhältnis h/d des Oberflächenprofils der Replizierschicht zu beeinflussen. Dadurch wird einerseits die Leitfähigkeit der metallischen Schicht beeinflußt und andererseits deren Transmission bzw. Transparenz.

Tabelle 1 zeigt den ermittelten Reflexionsgrad von zwischen Plastikfolien (Brechungsindex n = 1,5) angeordneten Metallschichten aus Ag, Al, Au, Cr, Cu, Rh und Ti bei einer Licht-Wellenlänge $\lambda$ = 550 nm. Das Dickenverhältnis $\varepsilon$ ist hierbei als Quotient aus der für den Reflexionsgrad R = 80% des Maximums $R_{max}$ und der für den Reflexionsgrad R = 20% des Maximums $R_{max}$ erforderlichen Dicke t der Metallschicht gebildet.

Tabelle 1

| Metall | $R_{Max}$ | t für 80 % $R_{Max}$ | t für 20% $R_{Max}$ | $\varepsilon$ | h/d |
|--------|-----------|----------------------|---------------------|---------------|------|
| Ag | 0,944 | 31 nm | 9 nm | 3,4 | 1,92 |
| Al | 0,886 | 12 nm | 2,5 nm | 4,8 | 2,82 |
| Au | 0,808 | 40 nm | 12 nm | 3,3 | 1,86 |
| Rh | 0,685 | 18 nm | 4,5 nm | 4,0 | 2,31 |
| Cu | 0,557 | 40 nm | 12 nm | 3,3 | 1,86 |
| Cr | 0,420 | 18 nm | 5 nm | 3,6 | 2,05 |
| Ti | 0,386 | 29 nm | 8,5 nm | 3,3 | 1,86 |

Aus der heuristischen Betrachtung heraus haben Silber und Gold (Ag und Au), wie zu sehen ist, einen hohen maximalen Reflexionsgrad $R_{Max}$ und erfordern ein relativ kleines Tiefen-zu-Breiten-Verhältnis zur Ausbildung von Transparenz. Aluminium (Al) hat zwar ein auch einen hohen maximalen Reflexionsgrad $R_{Max}$, erfordert aber ein höheres Tiefen-zu-Breiten-Verhältnis. Vorzugsweise kann deshalb vorgesehen sein, die Metallschicht aus Silber oder Gold auszubilden. Es kann aber auch vorgesehen sein, die Metallschicht aus anderen Metallen oder aus Metallegierungen auszubilden.

Tabelle 2 zeigt nun die Berechnungsergebnisse, gewonnen aus strengen Beugungsberechnungen für als lineare, sinusförmige Gitter mit einem Gitterabstand von 350 nm ausgebildete Oberflächenstrukturen mit unterschiedlichen Tiefen-zu-Breiten-Verhältnissen. Die Oberflächenstrukturen sind mit Silber beschichtet mit einer nominalen Dicke $t_0$ = 40 nm. Das Licht, das auf die Oberflächenstrukturen auftrifft, hat die Wellenlänge $\lambda$ = 550 nm (grün) und ist TE-polarisiert bzw. TM-polarisiert.

Tabelle 2

| Tiefen-zu-Breiten-Verhältnis | Gitterabstand in nm | Tiefe in nm | Reflexionsgrad (0R) TE | Transparenzgrad (0T) TE | Reflexionsgrad (0R) TM | Transparenzgrad (0T) TM |
|---|---|---|---|---|---|---|
| 0 | 350 | 0 | 84,5 % | 9,4 % | 84,5 % | 9,4 % |
| 0,3 | 350 | 100 | 78,4 % | 11,1 % | 50,0 % | 21,0 % |
| 0,4 | 350 | 150 | 42,0 % | 45,0 % | 31,0 % | 47,0 % |
| 1,1 | 350 | 400 | 2,3 % | 82,3 % | 1,6 % | 62,8 % |
| 2,3 | 350 | 800 | 1,2 % | 88,0 % | 0,2 % | 77,0 % |

Wie sich zeigte, ist insbesondere der Transparenzgrad außer vom Tiefen-zu-Breiten-Verhältnis abhängig von der Polarisation des aufgestrahlten Lichtes.

Diese Abhängigkeit ist in Tabelle 2 für verschiedene Tiefen-zu-Breiten-Verhältnisse h/d dargestellt.

Weiterhin zeigte sich, daß der Transparenzgrad bzw. der Reflexionsgrad der Metallschicht wellenlängenabhängig ist.
Dieser Effekt ist besonders gut für TE-polarisiertes Licht ausgeprägt.

Weiterhin zeigte sich, daß der Transparenzgrad abnimmt, wenn der Einfallswinkel des Lichtes sich vom normalen Einfallswinkel unterscheidet, d.h. der Transparenzgrad nimmt ab, wenn das Licht nicht senkrecht einfällt. Das bedeutet, daß die Metallschicht im Bereich der Oberflächenstruktur nur in einem begrenzten Einfallskegel des Lichtes transparent ausgebildet sein kann. Es kann also vorgesehen sein, daß die Metallschicht bei schräger Betrachtung opak ausgebildet ist, wobei dieser Effekt für die Verwendung der Metallschicht als selektive Belichtungsmaske nutzbar ist.

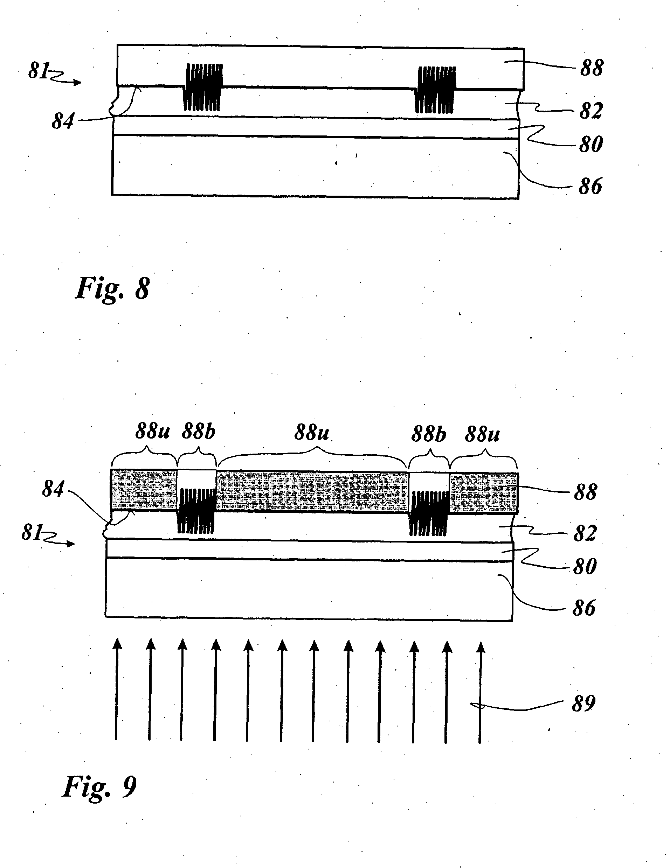

Die Fig. 8 bis 10 zeigen nun ein Ausführungsbeispiel zur Herstellung einer passergenau teildemetallisierten metallischen Schicht.

Fig. 8 zeigt einen mehrschichtigen Folienkörper 81, der wie der in Fig. 1 beschriebene Folienkörper 1 aufgebaut ist. Der Folienkörper 81 besteht aus mehreren Schichten. Im dargestellten Ausführungsbeispiel handelt es sich um eine Trägerfolie 80, eine Replizierschicht 82 und eine metallische Schicht 84, sowie um eine Kleberschicht 86, die auf der der Replizierschicht 82 abgewandten Seite der Trägerfolie 80 aufgetragen ist.

Auf die metallische Schicht 84 ist eine photoempfindliche Schicht 88 aufgetragen.

Bei der photoempfindlichen Schicht 88 kann es sich beispielsweise um einen UV-empfindlichen Photoresist handeln. Dabei kann es sich um eine organische Schicht handeln, die durch klassische Beschichtungsverfahren, wie Tiefdruck, in flüssiger Form aufgebracht wird. Es kann auch vorgesehen sein, daß die photoempfindliche Schicht aufgedampft wird oder als trockener Film auflaminiert wird.

In Fig. 9 ist die Belichtung der photoempfindlichen Schicht 88 von der Seite der Kleberschicht 86 her dargestellt, wobei die photoempfindliche Schicht 88 im entwickelten Zustand dargestellt ist.

Die Belichtung der photoempfindlichen Schicht 88 ist mit UV-Licht 89 vorgesehen, wobei die metallische Schicht 84 als Belichtungsmaske wirkt. Nach der Entwicklung weist die photoempfindliche Schicht 88 Bereiche 88u auf, in denen die Schicht 88 erhalten ist und Bereiche 88b auf, in denen die Schicht 88 infolge der Entwicklung entfernt ist. Wie in Fig. 9 zu erkennen ist, handelt es sich bei den Bereichen 88u um Bereiche, in denen die Replizierschicht 82 mit einem niedrigeren Tiefen-zu-Breiten-Verhältnis ausgebildet ist - im dargestellten Ausführungsbeispiel ist es Null - während in den Bereichen 88b die Replizierschicht 88 eine Oberflächenstruktur mit einem hohen Tiefen-zu-Breiten-Verhältnis aufweist. Dort ist die metallische Schicht 84 mit geringerer Dicke ausgebildet als in den Bereichen 88u, so daß die metallische Schicht 84 in beiden Bereiche eine unterschiedliche Transmission aufweist und somit das auftreffende UV-Licht in unterschiedlichem Maße abgeschwächt wird. Es ist nicht notwendig, die metallische Schicht so dünn auszubilden, daß die Bereiche 88b bei visueller Betrachtung transparent erscheinen. Eine relativ geringe Gesamttransmission des Folienkörpers 81 kann durch eine erhöhte Belichtungsdosis der photoempfindlichen Schicht 88 ausgeglichen werden. Weiter ist zu berücksichtigen, daß die Belichtung der photoempfindlichen Schicht typischerweise im nahen UV-Bereich vorgesehen ist, so daß der visuelle Betrachtungseindruck für die Beurteilung der Transmission nicht entscheidend ist.

In dem in den Fig. 8 bis 10 dargestellten Ausführungsbeispiel ist die photoempfindliche Schicht 88 aus einem positiven Photoresist ausgebildet. Bei einem solchen Photoresist sind die belichteten Bereiche im Entwickler löslich. Im Gegensatz dazu sind bei einem negativen Photoresist die unbelichteten Bereiche im Entwickler löslich. Es ist auf diese Weise möglich, mit einem Layout unterschiedliche Bereiche der metallischen Schicht 84 registergenau zu demetallisieren. Es kann weiter vorgesehen sein, die metallische Schicht 84 mit Hilfe einer nachfolgenden galvanischen Behandlung weiter zu modifizieren, beispielsweise mit erhöhter Schichtdicke auszubilden, um beispielsweise Leiterbahnen, wie weiter oben in Fig. 4 dargestellt, mit verbesserter elektrischer Leitfähigkeit auszubilden.

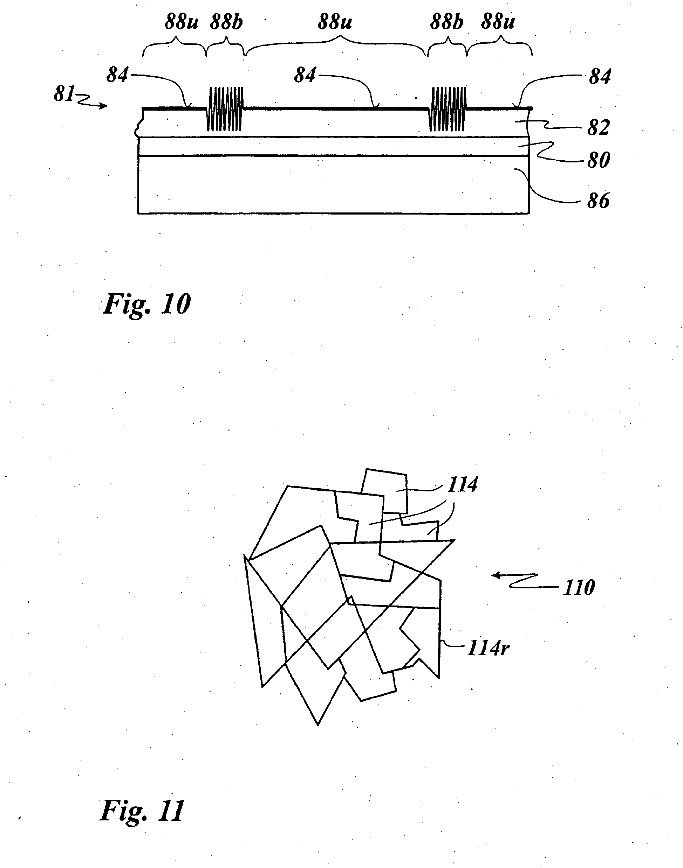

Fig. 10 zeigt nun den Folienkörper 81 in seinem Endzustand, nachdem mit Hilfe eines Ätzmittels die metallische Schicht 84 in den Bereichen 88b entfernt ist. Die metallische Schicht 84 ist also nur noch in den Bereichen 88u vorhanden und bildet auf diese Weise voneinander elektrisch isolierte Inseln.

Fig. 11 zeigt nun einen Mehrschichtkörper 110, der in zufälliger Weise in Inselbereiche 114 unterteilt ist. Demzufolge sind auch Rasterlinien 114r zufällig angeordnet und ausgebildet. In dem in Fig. 11 dargestellten Ausführungsbeispiel sind die Rasterlinien 114r als Geraden ausgebildet. Es kann sich dabei aber auch um gekrümmte Linien handeln. Weiter kann vorgesehen sein, daß die Linien mit variierender Breite ausgebildet sind. Um die weiter oben in Fig. 2 beschriebene Dimensionierungsformel F = D - B anwenden zu können bzw. das Verhältnis D/B bestimmen zu können, werden die Rasterweite D und die Breite B als Mittelwerte über alle Inselbereiche 114 ermittelt. Wie weiter oben in Fig. 3 beschrieben, kann vorzugsweise vorgesehen sein, daß die Variation der Rasterweite D < ± 40% ist.

Die Größe und Form der Inselbereiche 114 kann in einem großen Bereich variieren, ebenso die Lage der Schwerpunkte der Inselbereiche. Dennoch ist vorgesehen, daß die Inselbereiche typischerweise eine mittlere Größe < 250 μm aufweisen und das Verhältnis zwischen mittlerer Inselgröße und Breite der Unterbrechungen zwischen 5 und 200 ist.

In dem in Fig. 11 dargestellten Ausführungsbeispiel können die Inselbereiche 114 metallisiert sein und die durch die Rasterlinien 114r charakterisierte Hintergrundbereich demetallisiert sein oder umgekehrt.

**Patentansprüche**

1. Verfahren zur Herstellung eines Mehrschichtkörpers mit einstellbarer bzw. definierter elektrischer Leitfähigkeit,
   **dadurch gekennzeichnet,**
   **daß** in einem ersten Bereich einer Replizierschicht (12, 52a, 52b, 82) des Mehrschichtkörpers eine diffraktive erste Oberflächenstruktur abgeformt wird,
   **daß** eine metallische Schicht (14, 24, 34, 64, 84) auf die Replizierschicht (12, 52a, 52b, 82) in dem ersten Bereich und in einem zweiten Bereich, in dem die erste Oberflächenstruktur nicht in die Replizierschicht (12, 52a, 52b, 82) abgeformt ist, aufgebracht wird, wobei entweder der erste Bereich oder der zweite Bereich von einer Vielzahl mikroskopischer, mit einem unbewaffneten menschlichen Auge nicht wahrnehmbarer Musterbereiche gebildet wird, die in einem Linienraster oder in einem Flächenraster mit der Rasterweite D angeordnet sind und die jeweils durch den, jeden der Teilbereiche vollständig begrenzenden oder umschließenden zweiten Bereich bzw. ersten Bereich voneinander getrennt in einem Abstand B voneinander angeordnet sind,
   **daß** auf die metallische Schicht (14, 24, 34, 64, 84) eine photoempfindliche Schicht (88) aufgebracht wird oder als Replizierschicht eine photoempfindliche Waschmaske aufgebracht wird, daß die photoempfindliche Schicht (88) bzw. Waschmaske durch die metallische Schicht (14, 24, 34, 64, 84) hindurch belichtet wird, so daß die photoempfindliche Schicht (88) bzw. Waschmaske durch die erste Oberflächenstruktur bedingt im ersten und im zweiten Bereich unterschiedlich belichtet wird, und daß die metallische Schicht (14, 24, 34, 64, 84) unter Verwendung der belichteten photoempfindlichen Schicht (88) bzw. Waschmaske als Maskenschicht im ersten Bereich, nicht jedoch im zweiten Bereich, oder im zweiten Bereich, nicht jedoch im ersten Bereich entfernt wird.

2. Verfahren nach Anspruch 1,
   **dadurch gekennzeichnet,**
   **daß** die Rasterweite D im Bereich von 1 $\mu$m bis 500 $\mu$m gewählt wird, bevorzugt im Bereich von 5 $\mu$m bis 300 $\mu$m gewählt wird, und daß das Verhältnis der Rasterweite D zum Abstand B im Bereich von 5 bis 200 gewählt wird.

3. Verfahren nach Anspruch 1 oder 2,
   **dadurch gekennzeichnet,**
   **daß** die metallische Schicht (14, 24, 34, 64, 84) auf eine, von der Replizierschicht (12, 52a, 52b, 82) aufgespannte Ebene vollflächig in einer konstanten Flächendichte aufgebracht, vorzugsweise aufgedampft wird.

4. Verfahren nach einem der vorhergehenden Ansprüche,
   **dadurch gekennzeichnet,**
   **daß** die metallische Schicht (14, 24, 34, 64, 84) auf die Replizierschicht (12, 52a, 52b, 82) vollflächig in einer Dicke aufgebracht wird, bei der die metallische Schicht (14, 24, 34, 64, 84) in einem Bereich der Replizierschicht (12, 52a, 52b, 82) ohne Oberflächenstruktur eine optische Dichte zwischen 1 und 7 besitzt.

5. Verfahren nach einem der vorhergehenden Ansprüche,
   **dadurch gekennzeichnet,**
   **daß** in dem zweiten Bereich eine zweite Oberflächenstruktur in der Replizierschicht (12, 52a, 52b, 82) abgeformt ist und daß als erste diffraktive Oberflächenstruktur eine Oberflächenstruktur in die Replizierschicht (12, 52a, 52b, 82) abgeformt wird, die eine Transmission, insbesondere eine Transparenz der metallischen Schicht (14, 24, 34, 64, 84) im ersten Bereich gegenüber einer Transmission, insbesondere einer Transparenz der metallischen Schicht (14, 24, 34, 64, 84) in dem zweiten Bereich erhöht, oder umgekehrt.

6. Verfahren nach einem der vorhergehenden Ansprüche,
   **dadurch gekennzeichnet,**
   **daß** die erste Oberflächenstruktur eine größere Relieftiefe als die zweite Oberflächenstruktur besitzt, oder umgekehrt.

7. Verfahren nach einem der vorhergehenden Ansprüche,
   **dadurch gekennzeichnet,**
   **daß** das Produkt aus Spatialfrequenz und Relieftiefe der ersten Oberflächenstruktur größer als das Produkt aus Spatialfrequenz und Relieftiefe der zweiten Oberflächenstruktur ist oder umgekehrt.

8. Verfahren nach einem der vorhergehenden Ansprüche,
   **dadurch gekennzeichnet,**
   **daß** die erste oder zweite Oberflächenstruktur als optisch aktive, reflektierende oder transmittierende lichtbeugende und/oder lichtbrechende und/oder lichtstreuende Mikro- oder Nanostruktur ausgebildet ist, beispielsweise als Gitterstruktur, wie Lineargitter oder Kreuzgitter, als isotrope oder anisotrope Mattstruktur, als binäre oder kontinuierliche Fresnellinse, als Mikroprisma, als Blazegitter, als Kombinationsstruktur oder als Makrostruktur ausgebildet ist.

9. Verfahren nach einem der vorhergehenden Ansprüche,
   **dadurch gekennzeichnet,**
   **daß** in dem ersten Bereich als erste diffraktive Oberflächenstruktur eine Oberflächenstruktur mit einem hohem Tiefen-zu-Breiten-Verhältnis der einzelnen Strukturelemente, insbesondere mit einem Tiefen-zu-Breiten-Verhältnis > 0,3, abgeformt wird und daß die zweite Oberflächenstruktur als Oberflächenstruktur mit niedrigerem Tiefen-zu-Breiten-Verhältnis ausgebildet wird, oder umgekehrt.

10. Verfahren nach einem der vorhergehenden Ansprüche,
    **dadurch gekennzeichnet,**
    **daß** als photoempfindliche Schicht oder als photoempfindliche Waschmaske ein photoempfindliches Material mit einer binären Charakteristik aufgebracht wird und daß die photoempfindliche Schicht bzw. die photoempfindliche Waschmaske durch die metallische Schicht (14, 24, 34, 64, 84) hindurch in einer Belichtungsstärke und Belichtungsdauer belichtet wird, daß die photoempfindliche Schicht (88) bzw. die photoempfindliche Waschmaske im ersten Bereich, in dem die Transmission, insbesondere die Transparenz der metallischen Schicht (14, 24, 34, 64, 84) durch die erste Oberflächenstruktur bedingt erhöht ist, aktiviert wird und im zweiten Bereich nicht aktiviert wird, oder umgekehrt.

11. Verfahren nach Anspruch 10,
    **dadurch gekennzeichnet,**
    **daß** die photoempfindliche Schicht bzw. Waschmaske durch die metallische Schicht hindurch mittels UV-Strahlung belichtet wird.

12. Verfahren nach einem der vorhergehenden Ansprüche,
    **dadurch gekennzeichnet,**
    **daß** die durch die Belichtung aktivierten Bereiche der photoempfindlichen Waschmaske und die darauf angeordneten Bereiche der metallischen Schicht in einem Waschprozeß entfernt werden.

13. Verfahren nach einem der vorhergehenden Ansprüche,
    **dadurch gekennzeichnet,**
    **daß** die belichtete photoempfindliche Schicht (88) entwickelt wird und daß die entwickelte photoempfindliche Schicht eine Ätzmaske für die metallische Schicht (14, 24, 34, 64, 84) bildet.

14. Verfahren nach einem der vorhergehenden Ansprüche,
    **dadurch gekennzeichnet,**
    **daß** die photoempfindliche Schicht (88) durch die Belichtung im ersten oder im zweiten Bereich, in dem die Transmission, insbesondere die Transparenz der metallischen Schicht durch die erste Oberflächenstruktur bedingt erhöht ist, aktiviert wird, und daß die aktivierte photoaktivierbare Schicht ein Ätzmittel für die metallische Schicht bildet.

15. Verfahren nach einem der vorhergehenden Ansprüche,
    **dadurch gekennzeichnet,**
    **daß** die photoempfindliche Schicht aus einem Photoresist ausgebildet wird.

16. Verfahren nach einem der vorhergehenden Ansprüche;
    **dadurch gekennzeichnet,**
    **daß** die Überreste der Ätzmasken entfernt werden.

17. Verfahren nach einem der vorhergehenden Ansprüche,
    **dadurch gekennzeichnet,**
    **daß** die metallische Schicht (14, 24, 34, 64, 84) galvanisch verstärkt wird.

18. Verfahren nach einem der vorhergehenden Ansprüche,
**dadurch gekennzeichnet,**
**daß** im Register zu der metallischen Schicht mindestens eine transparente oder opake farbige Schicht angeordnet wird, insbesondere in dem von der metallischen Schicht (14, 24, 34, 64, 84) freien ersten oder zweiten Bereich angeordnet wird.

19. Mehrschichtkörper, insbesondere Transferfolie, erhältlich nach einem der Ansprüche 1 bis 18, mit einer Replizierschicht (12, 52a, 52b, 82), und einer auf der Replizierschicht (12, 52a, 52b, 82) angeordneten metallischen Schicht (14, 24, 34, 64, 84),
**dadurch gekennzeichnet,**
**daß** der Mehrschichtkörper eine Vielzahl mikroskopischer, mit einem unbewaffneten menschlichen Auge nicht wahrnehmbarer Musterbereiche und einen jeden der Musterbereiche vollständig begrenzenden oder umschließenden Hintergrundbereich aufweist, wobei die Musterbereiche in einem Linienraster oder in einem Flächenraster mit der Rasterweite D angeordnet sind; die Musterbereiche jeweils durch den Hintergrundbereich voneinander getrennt in einem Abstand B voneinander angeordnet sind, die Rasterweite D im Bereich von 5 $\mu$m bis 300$\mu$m liegt und das Verhältnis der Rasterweite D zum Abstand B im Bereich von 5 bis 200 liegt, und daß die metallische Schicht entweder im Hintergrundbereich oder in den Musterbereichen vorliegt.

20. Mehrschichtkörper nach Anspruch 19,
**dadurch gekennzeichnet,**
**dass** in einem ersten Bereich der Replizierschicht (12, 52a, 52b, 82) eine diffraktive erste Oberflächenstruktur abgeformt ist und in einem zweiten Bereich der Replizierschicht (12, 52a, 52b, 82) die erste Oberflächenstruktur nicht abgeformt ist, wobei die Musterbereiche entweder im ersten Bereich oder zweiten Bereich gebildet sind.

21. Mehrschichtkörper nach einem der Ansprüche 19 oder 20,
**dadurch gekennzeichnet,**
**daß** die Replizierschicht (12, 52a, 52b, 82) in den Musterbereichen eine erste Oberflächenstruktur und in dem Hintergrundbereich eine zweite Oberflächenstruktur aufweist, wobei sich die erste und die zweite Oberflächenstruktur von unterschiedlichen Oberflächenstrukturen gebildet werden und mindestens eine dieser Oberflächenstrukturen eine diffraktive Oberflächenstruktur ist.

22. Mehrschichtkörper nach einem der Ansprüche 19 bis 21,
**dadurch gekennzeichnet,**
**daß** die erste Oberflächenstruktur und die zweite Oberflächenstruktur ein unterschiedliches Tiefen-zu-Breiten-Verhältnis aufweisen.

23. Mehrschichtkörper nach einem der Ansprüche 19 bis 22
**dadurch gekennzeichnet,**
**daß** der Mehrschichtkörper eine zweite metallische Schicht (54b) aufweist, die im Register zu einer ersten metallischen Schicht (54a) angeordnet ist.

24. Mehrschichtkörper nach Anspruch 23,
**dadurch gekennzeichnet,**
**daß** mindestens eine der metallischen Schichten (54a, 54b) in einer Schichtdicke aufgebracht ist, bei der sie im sichtbaren Bereich teilweise transparent ist.

25. Mehrschichtkörper nach einem der Ansprüche 23 oder 24,
**dadurch gekennzeichnet,**
**daß** die metallischen Schichten (54a, 54b) im $(2n+1)\cdot\lambda/2$- oder $(4n+1)\cdot\lambda/4$-Abstand angeordnet sind, wobei n eine ganze Zahl einschließlich 0 und $\lambda$ die Wellenlänge bzw. die mittlere Wellenlänge des Lichtes ist, das für den Einsatzzweck des Mehrschichtkörpers vorgesehen ist, wobei $\lambda$ insbesondere im Bereich des sichtbaren Spektrums gewählt ist.

26. Mehrschichtkörper nach einem der Ansprüche 23 bis 25,
**dadurch gekennzeichnet,**
**daß** die metallischen Schichten (14, 24, 34, 64, 84) eine unterschiedliche erste Oberflächenstruktur und/oder zweite Oberflächenstruktur aufweisen und/oder daß ihre ersten Bereiche und/oder ihre zweiten Bereiche unterschiedlich angeordnet sind.

**27.** Mehrschichtkörper nach einem der Ansprüche 20 bis 26,
**dadurch gekennzeichnet,**
**daß** es sich bei der ersten Oberflächenstruktur und/oder bei der zweiten Oberflächenstruktur um eine beugungsoptische Oberflächenstruktur handelt, beispielsweise ein Hologramm, Kinegram® oder dergleichen.

**28.** Mehrschichtkörper nach einem der Ansprüche 20 bis 27,
**dadurch gekennzeichnet,**
**daß** es sich bei der ersten Oberflächenstruktur und/oder bei der zweiten Oberflächenstruktur um eine Mattstruktur handelt.

**29.** Mehrschichtkörper nach einem der Ansprüche 19 bis 28,
**dadurch gekennzeichnet,**
**daß** die Musterbereiche und/oder der Hintergrundbereich in Form eines Mikrotextes oder einer Mikrografik substrukturiert sind.

**30.** Mehrschichtkörper nach einem der Ansprüche 19 bis 29,
**dadurch gekennzeichnet,**
**daß** die Musterbereiche und/oder der Hintergrundbereich in Form eines versteckten Musters substrukturiert sind, das durch einen Moiré-Verifier erschließbar ist.

**31.** Mehrschichtkörper nach einem der Ansprüche 19 bis 30,
**dadurch gekennzeichnet,**
**daß** der Mehrschichtkörper weiterhin mindestens eine vollflächig oder partiell ausgebildete transparente oder opake farbige Schicht umfasst.

**32.** Mehrschichtkörper nach Anspruch 31,
**dadurch gekennzeichnet,**
**daß** die mindestens eine farbige Schicht im Register zu der metallischen Schicht ausgebildet ist, insbesondere in dem von der metallischen Schicht (14, 24, 34, 64, 84) freien ersten oder zweiten Bereich angeordnet ist.

**33.** Mehrschichtkörper nach einem der Ansprüche 31 oder 32,
**dadurch gekennzeichnet,**
**daß** die mindestens eine farbige Schicht als eine elektrisch leitfähige oder elektrisch isolierende Schicht ausgebildet ist.

**34.** Mehrschichtkörper nach einem der Ansprüche 31 bis 33,
**dadurch gekennzeichnet,**
**daß** die mindestens eine farbige Schicht musterförmig ausgebildet ist.

**35.** Mehrschichtkörper nach einem der Ansprüche 31 bis 34,
**dadurch gekennzeichnet,**
**daß** mindestens zwei, insbesondere mindestens drei farbige Schichten in unterschiedlicher Farbe ausgebildet sind.

**Claims**

**1.** Method for the production of a multilayer body having an adjustable or defined level of electrical conductivity,
**characterised in that**,
a diffractive first surface structure is moulded in a first region of a replication layer (12, 52a, 52b, 82) of the multilayer body,
a metallic layer (14, 24, 34, 64, 84) is applied to the replication layer (12, 52a, 52b, 82) in the first region and in a second region in which the first surface structure is not moulded into the replication layer (12, 52a, 52b, 82), wherein either the first region or the second region is formed by a plurality of microscopic pattern regions that cannot be perceived by a naked human eye, said regions being arranged in a linear grid or in a planar grid with the grid width D, and being arranged separated from one another at a distance B by the respective second region or first region that completely borders or encloses each of the partial regions,
a photosensitive layer (88) is applied to the metallic layer (14, 24, 34, 64, 84) or a photosensitive washing mask is applied as the replication layer, **in that** the photosensitive layer (88) or washing mask is exposed through the metallic layer (14, 24, 34, 64, 84), such that the photosensitive layer (88) or washing mask is exposed at different levels in the first and in the second region due to the first surface structure, and that the metallic layer (14, 24, 34, 64, 84) is removed by using the exposed photosensitive layer (88) or washing mask as the masking layer in the first region, but not in the second region, or in the second region but not the first region.

2. Method according to claim 1,
   **characterised in that**,
   the grid width D is selected to be in the range of 1µm to 500µm, preferably in the range from 5µm to 300µm, and the ratio of the grid width D to the distance B is selected to be in the range of 5 to 200.

3. Method according to claim 1 or 2,
   **characterised in that**,
   the metallic layer (14, 24, 34, 64, 84) is fully applied, preferably vapour deposited, onto a plane that is spanned by the replication layer (12, 52a, 52b, 82) at a constant areal density.

4. Method according to one of the preceding claims,
   **characterised in that**,
   the metallic layer (14, 24, 34, 64, 84) is applied fully to the replication layer (12, 52a, 52b, 82) at a thickness at which the metallic layer (14, 24, 34, 64, 84) has an optical density of between 1 and 7 in a region of the replication layer (12, 52a, 52b, 82) without a surface structure.

5. Method according to one of the preceding claims,
   **characterised in that**,
   a second surface structure is moulded in the replication layer (12, 52a, 52b, 82) in the second region and a surface structure is moulded into the replication layer (12, 52a, 52b, 82) as a first diffractive surface structure, which increases a transmission, in particular a transparency, of the metallic layer (14, 24, 34, 64, 84) in the first region compared to a transmission, in particular a transparency, of the metallic layer (14, 24, 34, 64, 84) in the second region, or vice versa.

6. Method according to one of the preceding claims,
   **characterised in that**,
   the first surface structure has a greater relief depth than the second surface structure, or vice versa.

7. Method according to one of the preceding claims,
   **characterised in that**,
   the product of spatial frequency and relief depth of the first surface structure is greater than the product of spatial frequency and relief depth of the second surface structure, or vice versa.

8. Method according to one of the preceding claims,
   **characterised in that**,
   the first or second surface structure is formed as an optically active, reflecting or transmitting, light-diffracting and/or refracting and/or scattering micro or nanostructure, for example as a grating structure such as a linear grating or cross grating, as an isotropic or anisotropic matt structure, as a binary or continuous Fresnel lens, as a microprism, a blazed grating, as a combination structure or as a macro structure.

9. Method according to one of the preceding claims,
   **characterised in that**,
   a surface structure having a high depth-to-width ratio of the individual structural elements, in particular having a depth-to-width ratio of >0.3, is moulded in the first region as a first diffractive surface structure, and **in that** the second surface structure is formed as a surface structure with a low depth-to-width ratio, or vice versa.

10. Method according to one of the preceding claims,
    **characterised in that**,
    a photosensitive material with a binary characteristic is applied as a photosensitive layer or as a photosensitive washing mask, and **in that** the photosensitive layer or the photosensitive washing mask is exposed through the metallic layer (14, 24, 34, 64, 84) at an exposure intensity and exposure duration, that the photosensitive layer (88) or the photosensitive washing mask is activated in the first region, in which the transmission, in particular the transparency, of the metallic layer (14, 24, 34, 64, 84) is increased due to the first surface structure, and is not activated in the second region, or vice versa.

**11.** Method according to claim 10,
**characterised in that**,
the photosensitive layer or washing mask is exposed through the metallic layer by means of UV radiation.

**12.** Method according to one of the preceding claims,
**characterised in that**,
the regions of the photosensitive washing mask that are activated by exposure and the regions of the metallic layer arranged thereon are removed in a washing process.

**13.** Method according to one of the preceding claims,
**characterised in that**,
the exposed photosensitive layer (88) is developed and the developed photosensitive layer forms an etching mask for the metallic layer (14, 24, 34, 64, 84).

**14.** Method according to one of the preceding claims, **characterised in that**,
the photosensitive layer (88) is activated by the exposure in the first or in the second region in which the transmission, in particular the transparency, of the metallic layer is increased due to the first surface structure, and **in that** the activated photoactivatable layer forms an etching agent for the metallic layer.

**15.** Method according to one of the preceding claims,
**characterised in that**,
the photosensitive layer is formed from a photoresist.

**16.** Method according to one of the preceding claims,
**characterised in that**,
the remains of the etching masks are removed.

**17.** Method according to one of the preceding claims,
**characterised in that**,
the metallic layer (14, 24, 34, 64, 84) is galvanically reinforced.

**18.** Method according to one of the preceding claims,
**characterised in that**,
at least one transparent or opaque, coloured layer is arranged in register with the metallic layer, in particular arranged in the first or second region that is free from the metallic layer (14, 24, 34, 64, 84).

**19.** Multilayer body, in particular a transfer film, which can be obtained according to one of claims 1 to 18, having a replication layer (12, 52a, 52b, 82) and a metallic layer (14, 24, 34, 64, 84) arranged on the replication layer (12, 52a, 52b, 82),
**characterised in that**,
the multilayer body has a plurality of microscopic pattern regions that cannot be perceived by a naked human eye and a background region that completely borders or encloses each of the pattern regions, wherein the pattern regions are arranged in a linear grid or in a planar grid with the grid width D, the pattern regions are each arranged separated from one another at a distance B, separated by the background region, the grid width D is in the range of $5\,\mu m$ to $300\,\mu m$ and the ratio of grid width D to distance B is in the range of 5 to 200, and **in that** the metallic layer is either present in the background region or in the pattern regions.

**20.** Multilayer body according to claim 19,
**characterised in that**,
a diffractive first surface structure is moulded in a first region of the replication layer (12, 52a, 52b, 82) and the first surface structure is not moulded in a second region of the replication layer (12, 52a, 52b, 82), wherein the pattern regions are either formed in the first region or in the second region.

**21.** Multilayer body according to one of claims 19 or 20, **characterised in that**,
the replication layer (12, 52a, 52b, 82) has a first surface structure in the pattern regions and a second surface structure in the background region, wherein the first and the second surface structures are formed by different surface structures and at least one of these surface structures is a diffractive surface structure.

**22.** Multilayer body according to one of claims 19 to 21, **characterised in that**,
the first surface structure and the second surface structure have a different depth-to-width ratio.

**23.** Multilayer body according to one of claims 19 to 22, **characterised in that**,
the multilayer body has a second metallic layer (54b) that is arranged in register with a first metallic layer (54a).

**24.** Multilayer body according to claim 23,
**characterised in that**,
at least one of the metallic layers (54a, 54b) is applied at a layer thickness at which it is partially transparent in the visible range.

**25.** Multilayer body according to one of claims 23 or 24, **characterised in that**,
the metallic layers (54a, 54b) are arranged at the distance $(2n+1).\lambda/2$ or $(4n+1).\lambda/4$, wherein n is an integer including 0, and $\lambda$ is the wavelength or the median wavelength of the light that is provided for the application purpose of the multilayer body, wherein $\lambda$ is in particular selected to be in the range of the visible spectrum.

**26.** Multilayer body according to one of claims 23 to 25,
**characterised in that**,
the metallic layers (14, 24, 34, 64, 84) have a different first surface structure and/or second surface structure, and/or **in that** their first regions and/or their second regions are arranged differently.

**27.** Multilayer body according to one of claims 20 to 26,
**characterised in that**,
the first surface structure and/or the second surface structure is an optically diffractive surface structure, for example a hologram, kinegram® or suchlike.

**28.** Multilayer body according to one of claims 20 to 27,
**characterised in that**,
the first surface structure and/or the second surface structure is a matt structure.

**29.** Multilayer body according to one of claims 19 to 28,
**characterised in that**,
the pattern regions and/or the background region are substructured in the form of a microtext and/or micrographic depiction.

**30.** Multilayer body according to one of claims 19 to 29,
**characterised in that**,
the pattern regions and/or the background region are substructured in the form of a hidden pattern that can be developed by a Moiré verifier.

**31.** Multilayer body according to one of claims 19 to 30,
**characterised in that**,
the multilayer body furthermore comprises at least one fully or partially formed transparent or opaque, coloured layer.

**32.** Multilayer body according to claim 31,
**characterised in that**,
the at least one coloured layer is formed in register with the metallic layer, in particular arranged in the first or second region that is free from the metallic layer (14, 24, 34, 64, 84).

**33.** Multilayer body according to one of claims 31 or 32,
**characterised in that**,
the at least one coloured layer is formed as an electrically conductive or electrically insulating layer.

**34.** Multilayer body according to one of claims 31 to 33,
**characterised in that**,
the at least one coloured layer is designed to be patterned.

**35.** Multilayer body according to one of claims 31 to 34,

**characterised in that**,
at least two, in particular at least three, coloured layers are formed with a different colour.

## Revendications

1. Procédé servant à fabriquer un corps multicouche présentant une conductivité électrique réglable ou définie, **caractérisé en ce que** :

   une première structure superficielle diffractive est formée dans une première zone d'une couche de réplication (12, 52a, 52b, 82) du corps multicouche, **en ce qu'**une couche métallique (14, 24, 34, 64, 84) est appliquée sur la couche de réplication (12, 52a, 52b, 82) dans la première zone et dans une deuxième zone, dans laquelle la première structure superficielle n'est pas formée dans la couche de réplication (12, 52a, 52b, 82), sachant que soit la première zone, soit la deuxième zone est formée par une pluralité de zones microscopiques à motifs non perceptibles à l'oeil nu, lesquelles sont disposées dans une trame linéaire ou dans une trame à plat présentant la largeur de trame D, et qui sont disposées à une distance B les unes des autres, et séparées les unes des autres respectivement par la deuxième zone ou la première zone entourant ou délimitant en totalité chacune des zones partielles, **en ce qu'**une couche photosensible (88) ou un masque de lavage photosensible, en tant que couche de réplication, est appliquée sur la couche métallique (14, 24, 34, 64, 84), **en ce que** la couche photosensible (88) ou le masque de lavage est éclairée à travers la couche métallique (14, 24, 34, 64, 84), de sorte que la couche photosensible (88) ou le masque de lavage est éclairée différemment du fait de la première couche superficielle dans la première et dans la deuxième zone, et **en ce que** la couche métallique (14, 24, 34, 64, 84) est supprimée en utilisant la couche photosensible (88) éclairée ou le masque de lavage en tant que couche de masque dans la première zone, mais pas dans la deuxième zone, ou dans la deuxième zone, mais pas dans la première zone.

2. Procédé selon la revendication 1, **caractérisé en ce que** :

   la largeur de trame D est choisie dans la plage allant de 1 $\mu$m à 500 $\mu$m, de préférence dans la plage allant de 5 $\mu$m à 300 $\mu$m, et **en ce que** le rapport entre la largeur de trame D et la distance B est choisie dans la plage allant de 5 à 200.

3. Procédé selon la revendication 1 ou 2, **caractérisé en ce que** :

   la couche métallique (14, 24, 34, 64, 84) est appliquée, de préférence est déposée en phase vapeur, sur un plan formé par la couche de réplication (12, 52a, 52b, 82), sur toute la surface, en une épaisseur constante.

4. Procédé selon l'une quelconque des revendications précédentes, **caractérisé en ce que** :

   la couche métallique (14, 24, 34, 64, 84) est appliquée sur la couche de réplication (12, 52a, 52b, 82), sur toute la surface, en une épaisseur pour laquelle la couche métallique (14, 24, 34, 64, 84) présente, dans une zone de la couche de réplication (12, 52a, 52b, 82) sans structure superficielle, une épaisseur optique comprise entre 1 et 7.

5. Procédé selon l'une quelconque des revendications précédentes, **caractérisé en ce que** :

   une deuxième structure superficielle est formée dans la couche de réplication (12, 52a, 52b, 82), dans la deuxième zone, et **en ce qu'**une structure superficielle est formée, en tant que première structure superficielle diffractive, dans la couche de réplication (12, 52a, 52b, 82), laquelle améliore une transmission, en particulier une transparence de la couche métallique (14, 24, 34, 64, 84) dans la première zone par rapport à une transmission, en particulier une transparence de la couche métallique (14, 24, 34, 64, 84) dans la deuxième zone, ou inversement.

6. Procédé selon l'une quelconque des revendications précédentes,

**caractérisé en ce que** :

la première structure superficielle comporte une profondeur de relief plus importante que la deuxième structure superficielle, ou inversement.

7. Procédé selon l'une quelconque des revendications précédentes,
**caractérisé en ce que** :

le produit de la fréquence spatiale et de la profondeur de relief de la première structure superficielle est plus grand que le produit de la fréquence spatiale et de la profondeur de relief de la deuxième structure superficielle, ou inversement.

8. Procédé selon l'une quelconque des revendications précédentes,
**caractérisé en ce que** :

la première ou la deuxième structure superficielle est réalisée sous la forme d'une microstructure ou d'une nanostructure active optiquement ayant des propriétés réfléchissantes ou transmettrices, diffractives et/ou réfractives et/ou dispersives, est réalisée par exemple sous la forme d'une structure de grille, telle qu'une grille linéaire ou une grille croisée, sous la forme d'une structure mate isotrope ou anisotrope, sous la forme d'une lentille de Fresnel binaire ou continue, sous la forme d'un microprisme, sous la forme d'une grille échelle, sous la forme d'une structure combinée ou sous la forme d'une macrostructure.

9. Procédé selon l'une quelconque des revendications précédentes,
**caractérisé en ce que** :

une structure superficielle dont les éléments structurels présentent un rapport élevé entre profondeur et largeur, en particulier un rapport entre profondeur et largeur > 0,3, est formée dans la première zone en tant que première structure superficielle diffractive, et **en ce que** la deuxième structure superficielle est réalisée sous la forme d'une structure superficielle présentant un rapport entre profondeur et largeur inférieur, ou inversement.

10. Procédé selon l'une quelconque des revendications précédentes,
**caractérisé en ce que** :

un matériau photosensible présentant une caractéristique binaire est appliqué, en tant que couche photosensible ou en tant que masque de lavage photosensible, et **en ce que** la couche photosensible ou le masque de lavage photosensible est éclairée selon une certaine intensité d'éclairage et une certaine durée d'éclairage à travers la couche métallique (14, 24, 34, 64, 84), **en ce que** la couche photosensible (88) ou le masque de lavage photosensible est activée dans la première zone, dans laquelle la transmission, en particulier la transparence de la couche métallique (14, 24, 34, 64, 84) est améliorée du fait de la première structure superficielle, et n'est pas activée dans la deuxième zone, ou inversement.

11. Procédé selon la revendication 10,
**caractérisé en ce que** :

la couche photosensible ou le masque de lavage est éclairée à travers la couche métallique au moyen d'un rayonnement infrarouge.

12. Procédé selon l'une quelconque des revendications précédentes,
**caractérisé en ce que** :

les zones activées par l'éclairage du masque de lavage photosensible et les zones disposées dessus de la couche métallique sont supprimées lors d'un processus de lavage.

13. Procédé selon l'une quelconque des revendications précédentes,
**caractérisé en ce que** :

la couche photosensible (88) éclairée est développée, et **en ce que** la couche photosensible développée forme un masque de gravure pour la couche métallique (14, 24, 34, 64, 84).

**14.** Procédé selon l'une quelconque des revendications précédentes,
**caractérisé en ce que** :

la couche photosensible (88) est activée par l'éclairage dans la première zone ou dans la deuxième zone, dans laquelle la transmission, en particulier la transparence de la couche métallique est améliorée du fait de la première structure superficielle, et **en ce que** la couche photoactivable activée forme un moyen de gravure pour la couche métallique.

**15.** Procédé selon l'une quelconque des revendications précédentes,
**caractérisé en ce que** :

la couche photosensible est réalisée à partir d'un photoresist.

**16.** Procédé selon l'une quelconque des revendications précédentes,
**caractérisé en ce que** :

les résidus des masques de gravure sont éliminés.

**17.** Procédé selon l'une quelconque des revendications précédentes,
**caractérisé en ce que** :

la couche métallique (14, 24, 34, 64, 84) est renforcée galvaniquement.

**18.** Procédé selon l'une quelconque des revendications précédentes,
**caractérisé en ce que** :

au moins une couche transparente ou colorée opaque est disposée dans le registre par rapport à la couche métallique, en particulier dans la première zone ou dans la deuxième zone dépourvue de la couche de la couche métallique (14, 24, 34, 64, 84).

**19.** Corps multicouche, en particulier film de transfert, pouvant être obtenu selon l'une quelconque des revendications 1 à 18, comprenant une couche de réplication (12, 52a, 52b, 82) et une couche métallique (14, 24, 34, 64, 84) disposée sur la couche de réplication (12, 52a, 52b, 82),
**caractérisé en ce que** :

le corps multicouche présente une pluralité de zones microscopiques à motifs non perceptibles à l'oeil nu et une zone d'arrière-plan délimitant en totalité ou entourant chacune des zones à motifs, sachant que les zones à motifs sont disposées dans une trame linéaire ou dans une trame à plat présentant la largeur de trame D, que les zones à motifs sont disposées à une distance B les unes des autres et séparées les unes des autres respectivement par la zone d'arrière-plan, que la largeur de trame D se trouve dans la plage allant de 5 $\mu$m à 300 $\mu$m et que le rapport entre la largeur de trame D et la distance B est situé dans la plage allant de 5 à 200, et **en ce que** la couche métallique est présente soit dans la zone d'arrière-plan, soit dans les zones à motifs.

**20.** Corps multicouche selon la revendication 19, **caractérisé en ce que** :

une première structure superficielle diffractive est formée dans la première zone de la couche de réplication (12, 52a, 52b, 82), et la première structure superficielle n'est pas formée dans une deuxième zone de la couche de réplication (12, 52a, 52b, 82), sachant que les zones à motifs sont formées soit dans la première zone, soit dans la deuxième zone.

**21.** Corps multicouche selon l'une quelconque des revendications 19 ou 20,
**caractérisé en ce que** :

la couche de réplication (12, 52a, 52b, 82) présente, dans les zones à motifs, une première structure superficielle et, dans la zone d'arrière-plan, une deuxième couche superficielle, sachant que la première et la deuxième structure superficielle sont formées par diverses structures superficielles et qu'au moins une desdites structures superficielles est une structure superficielle diffractive.

**22.** Corps multicouche selon l'une quelconque des revendications 19 à 21,
**caractérisé en ce que** :

la première structure superficielle et la deuxième structure superficielle présentent un rapport différent entre profondeur et largeur.

**23.** Corps multicouche selon l'une quelconque des revendications 19 à 22,
**caractérisé en ce que** :

le corps multicouche présente une deuxième couche métallique (54b) qui est disposée dans le registre par rapport à une première couche métallique (54a).

**24.** Corps multicouche selon la revendication 23,
**caractérisé en ce que** :

au moins une des couches métalliques (54a, 54b) est appliquée en une épaisseur de couche, pour laquelle elle est partiellement transparente dans la zone visible.

**25.** Corps multicouche selon l'une quelconque des revendications 23 ou 24,
**caractérisé en ce que** :

les couches métalliques (54a, 54b) sont disposées à la distance $(2n+1).\lambda/2$ ou $(4n+1).\lambda/4$, sachant que n est un nombre entier, 0 y compris, et que $\lambda$ est la longueur d'onde ou la longueur d'onde moyenne de la lumière, qui est prévue pour le type d'application du corps multicouche, sachant que $\lambda$ est choisi en particulier dans la plage du spectre visible.

**26.** Corps multicouche selon l'une quelconque des revendications 23 à 25,
**caractérisé en ce que** :

les couches métalliques (14, 24, 34, 64, 84) présentent une première structure superficielle différente et/ou une deuxième structure superficielle différente, et/ou **en ce que** leurs premières zones et/ou leurs deuxièmes zones sont disposées différemment.

**27.** Corps multicouche selon l'une quelconque des revendications 20 à 26,
**caractérisé en ce que** :

la première structure superficielle et/ou la deuxième structure superficielle sont une structure superficielle à diffraction optique, par exemple un hologramme, un kinegram® ou similaire.

**28.** Corps multicouche selon l'une quelconque des revendications 20 à 27,
**caractérisé en ce que** :

la première couche superficielle et/ou la deuxième couche superficielle est une structure mate.

**29.** Corps multicouche selon l'une quelconque des revendications 19 à 28,
**caractérisé en ce que** :

que les zones à motifs et/ou la zone d'arrière-plan sont sous-structurées sous la forme d'un microtexte ou d'un micrographique.

**30.** Corps multicouche selon l'une quelconque des revendications 19 à 29,
**caractérisé en ce que** :

les zones à motifs et/ou la zone d'arrière-plan sont sous-structurées sous la forme d'un motif dissimulé, qui peut être deviné par un vérificateur moiré.

**31.** Corps multicouche selon l'une quelconque des revendications 19 à 30,
**caractérisé en ce que** :

le corps multicouche comprend en outre au moins une couche transparente ou colorée opaque réalisée sur toute la surface ou de manière partielle.

**32.** Corps multicouche selon la revendication 31, **caractérisé en ce que** :

la couche colorée au moins au nombre de une est réalisée dans le registre par rapport à la couche métallique, en particulier dans la première ou la deuxième zone dépourvue de la couche métallique (14, 24, 34, 64, 84).

**33.** Corps multicouche selon l'une quelconque des revendications 31 ou 32, **caractérisé en ce que** :

la couche colorée au moins au nombre de une est réalisée sous la forme d'une couche électroconductrice ou isolante électriquement.

**34.** Corps multicouche selon l'une quelconque des revendications 31 à 33, **caractérisé en ce que** :

la couche colorée au moins au nombre de une est réalisée de manière à présenter la forme d'un motif.

**35.** Corps multicouche selon l'une quelconque des revendications 31 à 34, **caractérisé en ce que** :

au moins deux, en particulier, au moins trois couches colorées, sont réalisées dans différentes couleurs.

II

1

14
12
10
16

**Fig. 1**

14d

1

14m

D

F

14r

B

y

x

14r

**Fig. 2**

24

24m

24d

**Fig. 3**

34d

3

34l

34l

34m

34

**Fig. 4**

**Fig. 5**

50
52a
54a
52b
54b
56

**Fig. 6**

68

64d

64m

64

**Fig. 7**

81↝ →

84

88

82

80

86

## Fig. 8

88u  88b        88u        88b  88u

84

81↝ →

88

82

80

86

89

## Fig. 9

88u 88b · 88u 88b 88u

84 84 84

81 82

80

86

**Fig. 10**

114

110

114r

**Fig. 11**